# EUROPEAN PATENT APPLICATION

(11) **EP 4 528 117 A1**
(43) Date of publication of application: **26.03.2025**
(21) Application number: 23909324.8
(22) Date of filing: 08.09.2023
(51) Int. Cl.: F16C 11/04, F16C 11/00, G09F 9/30, H04M 1/02, H05K 5/02, G06F 1/16

(54) **ROTATING MECHANISM AND FOLDABLE ELECTRONIC DEVICE**

(30) Priority: 29.12.2022 CN 202211711390
(71) Applicant: Honor Device Co., Ltd., Shenzhen, Guangdong 518040 (CN)
(72) Inventor: LIU, Xiaodong, Shenzhen, Guangdong 518040 (CN); CHEN, Ruihao, Shenzhen, Guangdong 518040 (CN); DONG, Shaohong, Shenzhen, Guangdong 518040 (CN)
(74) Representative: Goddar, Heinz J.
(86) International application number: PCT/CN2023/117607
(87) International publication number: WO 2024/139386

(57) **Abstract**

This application provides a rotating mechanism and a foldable electronic device. The rotating mechanism includes a fixed base, a first fastening frame, a second fastening frame, a first main swing arm, and a first intermediate swing arm. The first fastening frame and the second fastening frame are respectively located on two opposite sides of the fixed base in a width direction, and are capable of rotating relative to the fixed base, and rotation directions of the first fastening frame and the second fastening frame are opposite. One end of the first main swing arm is rotatably connected to the fixed base, the other end of the first main swing arm is rotatably connected to the first intermediate swing arm, and an end that is of the first intermediate swing arm and that is away from the first main swing arm is rotatably connected to the first fastening frame. The rotating mechanism provided in this application can resolve a technical problem that a thickness of the rotating mechanism is large when the rotating mechanism is in a folded state in the conventional technology.

## Description

This application claims priority to Chinese Patent Application No. 202211711390.4, filed with the China National Intellectual Property Administration on December 29, 2022 and entitled "ROTATING MECHANISM AND FOLDABLE ELECTRONIC DEVICE", which is incorporated herein by reference in its entirety.

### TECHNICAL FIELD

This application relates to the field of electronic product technologies, and in particular, to a rotating mechanism and a foldable electronic device.

### BACKGROUND

With development of science and technologies, an appearance (ID) form of an electronic device (for example, a cellphone or a tablet personal computer) tends to develop from a bar-type device to a foldable device. The foldable device has a large-area screen in an open state and therefore fully meets visual experience of a consumer; and has a small volume in a closed state and therefore is easy to carry. In rotation solutions used for a foldable device in a conventional technology, mostly, a swing arm and a base implement virtual-pivot rotation by using a rotating sliding block. In such solutions, because a constraint is involved, a swing arm protrudes by a distance in a folding thickness direction of the entire device in a folded state, resulting in a large thickness of the foldable device, which is not conducive to lightness and thinning of the foldable device.

### SUMMARY

This application provides a rotating mechanism and a foldable electronic device, to resolve a technical problem that a thickness of the rotating mechanism is large when the rotating mechanism is in a folded state in the conventional technology.

According to a first aspect, this application provides a rotating mechanism, including a fixed base, a first fastening frame, a second fastening frame, a first main swing arm, and a first intermediate swing arm. The first fastening frame and the second fastening frame are respectively located on two opposite sides of the fixed base in a width direction, and are capable of rotating relative to the fixed base, and rotation directions of the first fastening frame and the second fastening frame are opposite. One end of the first main swing arm is rotatably connected to the fixed base, the other end of the first main swing arm is rotatably connected to the first intermediate swing arm, and an end that is of the first intermediate swing arm and that is away from the first main swing arm is rotatably connected to the first fastening frame.

The rotating mechanism is applied to a foldable electronic device, and the foldable electronic device includes a first housing, a second housing, and a display. The first housing is fixedly connected to the first fastening frame, and the second housing is fixedly connected to the second fastening frame. The rotating mechanism is located between the first housing and the second housing, and enables the first housing to be rotatably connected to the second housing. Rotation of the rotating mechanism can drive the first housing and the second housing to rotate relative to each other. Accommodation grooves are further disposed in the first housing and the second housing. The accommodation grooves are configured to accommodate electronic elements such as a processor, a circuit board, and a camera module, and a structural element of the electronic device. When the rotating mechanism is in a folded state, the first fastening frame and the second fastening frame are folded relative to each other, and the display is bent. When the rotating mechanism is in a fully unfolded state, the first fastening frame and the second fastening frame are fully unfolded relative to the fixed base, an included angle between the first fastening frame and the second fastening frame is close to 180 degrees, the display is unfolded, and the display has a large-area display region, to implement large-screen display of the foldable electronic device, thereby improving use experience of a user.

In this embodiment, the first intermediate swing arm is disposed between the first main swing arm and the first fastening frame. When the first fastening frame and the first main swing arm rotate relative to the fixed base, the first intermediate swing arm is capable of rotating relative to the first main swing arm, to compensate for a rotation angle of the first main swing arm relative to the fixed base and reduce the rotation angle of the first main swing arm relative to the fixed base, so that a distance by which the first main swing arm protrudes from a side surface of the fixed base when the rotating mechanism is in the folded state can be reduced, thereby reducing space occupied by the first main swing arm in a thickness direction when the rotating mechanism is in the folded state and reducing a thickness of the rotating mechanism in the folded state. In this way, lightness and thinning of the foldable electronic device are implemented.

In a possible implementation, the fixed base includes a first side and a second side, and the first side and the second side are respectively located on the two opposite sides of the fixed base in the width direction; and the rotating mechanism includes the folded state, and when the rotating mechanism is in the folded state, the first main swing arm is located between the first side and the second side.

In this embodiment, when the rotating mechanism is in the folded state, the first main swing arm is located between the first side and the second side, so that when the rotating mechanism is in the folded state, the first main swing arm protrudes from the side surface of the fixed base, thereby reducing the space occupied by the first main swing arm in the thickness direction of the rotating mechanism and reducing the thickness of the rotating mechanism in the folded state. In this way, lightness and thinning of the foldable electronic device are implemented.

In a possible implementation, when the rotating mechanism is in the folded state, the first intermediate swing arm is tilted toward the fixed base relative to the first main swing arm.

In this embodiment, when the rotating mechanism is in the folded state, the first intermediate swing arm is disposed to be tilted toward the fixed base relative to the first main swing arm, to compensate for the rotation angle of the first main swing arm relative to the fixed base when the rotating mechanism is in the folded state, thereby reducing the distance by which the first main swing arm protrudes from the side surface of the fixed base when the rotating mechanism is in the folded state, reducing space occupation of the first main swing arm in the thickness direction when the rotating mechanism is in the folded state, and reducing the thickness of the rotating mechanism in the folded state.

In a possible implementation, the rotating mechanism further includes the fully unfolded state, when the rotating mechanism is in the fully unfolded state, the first fastening frame is unfolded relative to the second fastening frame, and when the first fastening frame and the second fastening frame rotate toward the fixed base, the first fastening frame drives the first intermediate swing arm to rotate relative to the fixed base, and enables the first intermediate swing arm to rotate relative to the first fastening frame, and the first intermediate swing arm rotates to drive the first main swing arm to rotate relative to the fixed base, and enables the first main swing arm to rotate relative to the first intermediate swing arm, so that the first fastening frame is folded relative to the second fastening frame, and the rotating mechanism is in the folded state.

When the rotating mechanism is in the fully unfolded state, the first fastening frame is unfolded relative to the second fastening frame, and the first fastening frame and the second fastening frame are jointly configured to support a foldable part of the display, to ensure good display of the display. In this embodiment, when the rotating mechanism rotates from the folded state to the fully unfolded state, all of the first fastening frame, the first intermediate swing arm, and the first main swing arm rotate toward the fixed base, and the first intermediate swing arm further rotates relative to the first main swing arm, so that in a process in which the rotating mechanism rotates from the folded state to the fully unfolded state, the rotation angle of the first main swing arm relative to the fixed base can be reduced, the distance by which the first main swing arm protrudes from the side surface of the fixed base when the rotating mechanism is in the folded state can be reduced, and space occupation of the first main swing arm in the thickness direction when the rotating mechanism is in the folded state can be reduced. In other words, the thickness of the rotating mechanism in the folded state is reduced. Further, lightness and thinning of the foldable electronic device are implemented.

In a possible implementation, the first main swing arm includes a first rotating body and a first stop block, and the first stop block is fixedly connected to an end of the first rotating body. Both the first stop block and the first rotating body are installed in the fixed base, and are capable of rotating in the fixed base, an end that is of the first rotating body and that is away from the first stop block is rotatably connected to the first intermediate swing arm, and when the rotating mechanism is in the folded state, the first stop block abuts against the fixed base.

In this embodiment, the first stop block is disposed on the first main swing arm, to stop the first main swing arm, so that when the rotating mechanism is in the folded state, the first main swing arm is prevented from being detached from the fixed base, thereby improving structural stability of the rotating mechanism.

In a possible implementation, the rotating mechanism further includes a second main swing arm and a second intermediate swing arm, the second main swing arm is disposed opposite to the first main swing arm, one end of the second main swing arm is rotatably connected to the fixed base, the other end of the second main swing arm is rotatably connected to the second intermediate swing arm, and an end that is of the second intermediate swing arm and that is away from the second main swing arm is rotatably connected to the second fastening frame. When rotating relative to the fixed base, the second fastening frame drives the second intermediate swing arm to rotate relative to the fixed base, and enables the second intermediate swing arm to rotate relative to the second fastening frame, and the second intermediate swing arm rotates to drive the second main swing arm to rotate relative to the fixed base, and enables the second main swing arm to rotate relative to the second intermediate swing arm.

In this embodiment, the second intermediate swing arm is disposed between the second main swing arm and the second fastening frame. When the second fastening frame and the second main swing arm rotate relative to the fixed base, the second intermediate swing arm is capable of rotating relative to the second main swing arm, to compensate for a rotation angle of the second main swing arm relative to the fixed base and reduce the rotation angle of the second main swing arm relative to the fixed base, so that a distance by which the second main swing arm protrudes from a side surface of the fixed base when the rotating mechanism is in the folded state can be reduced, thereby reducing space occupied by the second main swing arm in the thickness direction when the rotating mechanism is in the folded state and further reducing the thickness of the rotating mechanism in the folded state. In this way, lightness and thinning of the foldable electronic device are further implemented.

In a possible implementation, the rotating mechanism further includes a first pressing plate and a second pressing plate, the first pressing plate is slidably and rotatably connected to the first fastening frame, and when rotating relative to the fixed base, the first fastening frame is capable of driving the first pressing plate to rotate relative to the fixed base and enabling the first pressing plate to rotate and slide relative to the first fastening frame; and the second pressing plate is slidably connected to the second fastening frame, and when rotating relative to the fixed base, the second pressing plate is capable of driving the second pressing plate to rotate relative to the fixed base and enabling the second pressing plate to rotate and slide relative to the second fastening frame.

In this embodiment, the first pressing plate and the second pressing plate are disposed, and when the rotating mechanism is in the fully unfolded state, the first pressing plate and the second pressing plate jointly support the display, so that connection stability of the display can be improved, thereby ensuring good display of the display.

In a possible implementation, the first main swing arm and the first pressing plate are disposed side by side in a length direction of the fixed base, and the first main swing arm is rotatably and slidably connected to the first pressing plate; and when the first pressing plate and the first main swing arm rotate relative to the fixed base, the first main swing arm further rotates and slides relative to the first pressing plate.

In this embodiment, the first pressing plate and the first main swing arm are slidably and rotatably connected to each other, so that the first pressing plate and the first main swing arm can simultaneously rotate relative to the fixed base, to implement rotation of the first pressing plate relative to the fixed base, thereby improving stability of rotation of the first pressing plate. In addition, a pressing plate swing arm can be saved, in other words, in this embodiment, stable rotation of the first pressing plate can be implemented without the pressing plate swing arm, so that a structure of the rotating mechanism is simplified, thereby helping implement lightness and thinning of the foldable electronic device.

In a possible implementation, a first shaft body is disposed on a side surface of the first main swing arm, the first shaft body extends toward the first pressing plate, and an extension direction of the first shaft body is parallel to the length direction of the fixed base; and the first pressing plate is provided with a first sliding hole, an extension direction of the first sliding hole intersects the width direction of the fixed base, and the first shaft body is installed in the first sliding hole, and is capable of rotating and sliding in the first sliding hole.

In this embodiment, the first shaft body is disposed on the side surface of the first main swing arm, the first pressing plate is provided with the first sliding hole, and the first shaft body is installed in the first sliding hole, so that when the first main swing arm rotates relative to the first pressing plate, the first shaft body rotates and slides in the first sliding hole, thereby improving stability of a connection between the first main swing arm and the first pressing plate.

In a possible implementation, the first intermediate swing arm and the first pressing plate are disposed side by side in the length direction of the fixed base, and the first intermediate swing arm is rotatably and slidably connected to the first pressing plate; and when the first pressing plate and the first intermediate swing arm rotate relative to the fixed base, the first intermediate swing arm further rotates and slides relative to the first pressing plate.

In this embodiment, the first pressing plate and the first intermediate swing arm are slidably and rotatably connected to each other, so that the first pressing plate and the first intermediate swing arm can simultaneously rotate relative to the fixed base, to implement rotation of the first pressing plate relative to the fixed base, thereby further improving stability of rotation of the first pressing plate.

In a possible implementation, a second shaft body is disposed on a side surface of the first intermediate swing arm, the second shaft body extends toward the first pressing plate, and an extension direction of the second shaft body is parallel to the length direction of the fixed base; and the first pressing plate is provided with a second sliding hole, an extension direction of the second sliding hole is parallel to the extension direction of the first sliding hole, and the second shaft body is installed in the second sliding hole, and is capable of rotating and sliding in the second sliding hole.

In this embodiment, the second shaft body is disposed on the side surface of the first intermediate swing arm, the first pressing plate is provided with the second sliding hole, and the second shaft body is installed in the second sliding hole, so that when the first intermediate swing arm rotates relative to the first pressing plate, the second shaft body rotates and slides in the second sliding hole, thereby improving stability of a connection between the first intermediate swing arm and the first pressing plate.

In a possible implementation, the second main swing arm and the second pressing plate are disposed side by side in the length direction of the fixed base, and the second main swing arm is rotatably and slidably connected to the second pressing plate; and when the second pressing plate and the second main swing arm rotate relative to the fixed base, the second main swing arm further rotates and slides relative to the second pressing plate.

In this embodiment, the second pressing plate and the second main swing arm are slidably and rotatably connected to each other, so that the second pressing plate and the second main swing arm can simultaneously rotate relative to the fixed base, to implement rotation of the second pressing plate relative to the fixed base, thereby improving stability of rotation of the second pressing plate. In addition, a pressing plate swing arm can be saved, in other words, in this embodiment, stable rotation of the second pressing plate can be implemented without the pressing plate swing arm, so that the structure of the rotating mechanism is simplified, thereby helping implement lightness and thinning of the foldable electronic device.

In a possible implementation, the second intermediate swing arm and the second pressing plate are disposed side by side in the length direction of the fixed base, and the second intermediate swing arm is rotatably and slidably connected to the second pressing plate; and when the second pressing plate and the second intermediate swing arm rotate relative to the fixed base, the second intermediate swing arm further rotates and slides relative to the first pressing plate.

In this embodiment, the second pressing plate and the second intermediate swing arm are slidably and rotatably connected to each other, so that the second pressing plate and the second intermediate swing arm can simultaneously rotate relative to the fixed base, to implement rotation of the second pressing plate relative to the fixed base, thereby further improving stability of rotation of the second pressing plate.

In a possible implementation, the rotating mechanism further includes a synchronization assembly, the synchronization assembly includes a first synchronization swing arm, a second synchronization swing arm, and a synchronization gear, and the first synchronization swing arm and the second synchronization swing arm are respectively located on two opposite sides of the synchronization gear, and are fixedly connected to the synchronization gear; and the synchronization gear is installed in the fixed base, the first synchronization swing arm is slidably connected to the first fastening frame, and the second synchronization swing arm is slidably connected to the second fastening frame. When rotating relative to the fixed base, the first fastening frame is capable of driving the first synchronization swing arm to rotate relative to the fixed base, so that the second synchronization swing arm is driven, by using the synchronization gear, to rotate relative to the fixed base, to drive the second fastening frame to rotate relative to the fixed base.

In this embodiment, the synchronization assembly is disposed, and when rotating, the first synchronization swing arm can drive, by using the synchronization gear, the second synchronization swing arm to rotate, so that synchronous rotation of the first synchronization swing arm and the second synchronization swing arm can be implemented, thereby implementing synchronous rotation of the rotating mechanism and the foldable electronic device.

In a possible implementation, the synchronization assembly further includes a damping spring, a first hinge seat, and a second hinge seat, the damping spring is installed on the fixed base, and both the first hinge seat and the second hinge seat are fixedly connected to the damping spring; and the first synchronization swing arm includes a first hinge body, the first hinge body is hinged to the first hinge seat, the second synchronization swing arm includes a second hinge body, and the second hinge body is hinged to the second hinge seat. When the first synchronization swing arm rotates relative to the fixed base, the first hinge body abuts against the first hinge seat, when the second synchronization swing arm rotates relative to the fixed base, the second hinge body abuts against the second hinge seat, and the first hinge seat and the second hinge seat jointly compress the damping spring, and enable the damping spring to generate an elastic force.

In this embodiment, the damping spring is disposed; and the first hinge body is disposed in the first synchronization swing arm, and the second hinge body is disposed in the second synchronization swing arm, so that when rotating, the first synchronization swing arm and the second synchronization swing arm repeatedly push the first hinge seat and the second hinge seat to repeatedly squeeze the damping spring to generate an elastic force. An elastic restoring force generated by the elastic force acts on the first synchronization swing arm and the second synchronization swing arm in turn, to provide a damping force for rotation of the first synchronization swing arm and the second synchronization swing arm, thereby improving a damping hand feel of the user during use and improving use experience of the user.

This application further provides a foldable electronic device, including a first housing, a second housing, a display, and the foregoing rotating mechanism. The rotating mechanism is connected between the first housing and the second housing, the display is installed on the first housing, the second housing, and the rotating mechanism, and when the rotating mechanism rotates, the first housing and the second housing rotate relative to each other, to drive the display to be bent or unfolded.

When the foldable electronic device is in a fully unfolded state, the first housing, the second housing, and the rotating mechanism jointly support the display, to ensure normal display of the display and also implement large-screen display, thereby improving use experience of a user. When the foldable electronic device is in a folded state, a foldable part of the display is bent, and a first part and a second part are disposed opposite to each other. In this case, the display is located between the first housing and the second housing, and an exposed area of the display is small, so that a probability of damage to the display can be greatly reduced, thereby effectively protecting the display. In addition, in this embodiment, a first intermediate swing arm is disposed between a first fastening frame and a first main swing arm of the rotating mechanism, so that a rotation angle of the first main swing arm relative to a fixed base can be reduced, and a thickness of the foldable electronic device when the foldable electronic device is in the folded state can be reduced, thereby implementing lightness and thinning of the foldable electronic device.

In conclusion, in this application, the first intermediate swing arm is disposed between the first main swing arm and the first fastening frame. When the first fastening frame and the first main swing arm rotate relative to the fixed base, the first intermediate swing arm is capable of rotating relative to the first main swing arm, to compensate for the rotation angle of the first main swing arm relative to the fixed base and reduce the rotation angle of the first main swing arm relative to the fixed base, so that the distance by which the first main swing arm protrudes from the side surface of the fixed base when the rotating mechanism is in the folded state can be reduced, thereby reducing the space occupied by the first main swing arm in the thickness direction when the rotating mechanism is in the folded state and reducing the thickness of the rotating mechanism in the folded state. In this way, lightness and thinning of the foldable electronic device are implemented.

### BRIEF DESCRIPTION OF DRAWINGS

To describe technical solutions in embodiments or the background of this application more clearly, the following describes accompanying drawings required in the embodiments or the background of this application.
FIG. 1 is a schematic diagram of a structure of a foldable electronic device in a first state according to an embodiment of this application;
FIG. 2 is a schematic diagram of a structure of a foldable electronic device in a second state according to an embodiment of this application;
FIG. 3 is a schematic diagram of a structure of a foldable electronic device in a third state according to an embodiment of this application;
FIG. 4 is a schematic exploded view of a structure of the foldable electronic device shown in FIG. 3;
FIG. 5 is a schematic diagram of a structure of a rotating mechanism in the foldable electronic device shown in FIG. 4;
FIG. 6 is a schematic exploded view of a structure of the rotating mechanism shown in FIG. 5;
FIG. 7 is a schematic exploded view of a structure of a fixed base in the rotating mechanism shown in FIG. 6;
FIG. 8 is a schematic diagram of a partial enlarged structure of the fixed base shown in FIG. 7;
FIG. 9 is a schematic diagram of an enlarged structure of a fastening frame in the rotating mechanism shown in FIG. 6;
FIG. 10 is a schematic diagram of an enlarged structure of a first swing arm assembly in the rotating mechanism shown in FIG. 6;
FIG. 11 is a schematic diagram of a partial structure of the rotating mechanism shown in FIG. 5 in a fully unfolded state;
FIG. 12 is a schematic diagram of a cross-sectional structure of the rotating mechanism shown in FIG. 5 in a fully unfolded state;
FIG. 13 is a schematic diagram of a cross-sectional structure of the rotating mechanism shown in FIG. 12 in a folded state;
FIG. 14 is a schematic diagram of an enlarged structure of a pressing plate in the rotating mechanism shown in FIG. 6;
FIG. 15 is a schematic diagram of a cross-sectional structure of the rotating mechanism shown in FIG. 5;
FIG. 16 is a schematic diagram of a cross-sectional structure of the rotating mechanism shown in FIG. 15 in a folded state;
FIG. 17 is a schematic exploded view of a structure of a synchronization assembly in the rotating mechanism shown in FIG. 6;
FIG. 18 is a schematic diagram of a structure of the rotating mechanism shown in FIG. 5 in a folded state;
FIG. 19 is a schematic diagram of a partial structure of a rotating mechanism according to a second embodiment of this application;
FIG. 20 is a schematic exploded view of a partial structure of the rotating mechanism shown in FIG. 19;
FIG. 21 is a schematic diagram of a partial structure of a rotating mechanism according to a third embodiment of this application;
FIG. 22 is a schematic exploded view of a partial structure of the rotating mechanism shown in FIG. 21;
FIG. 23 is a schematic diagram of a partial structure of a rotating mechanism according to a fourth embodiment of this application;
FIG. 24 is a schematic exploded view of a partial structure of the rotating mechanism shown in FIG. 23;
FIG. 25 is a schematic diagram of a partial structure of a rotating mechanism according to a fifth embodiment of this application;
FIG. 26 is a schematic exploded view of a partial structure of the rotating mechanism shown in FIG. 25;
FIG. 27 is a schematic diagram of a partial structure of a rotating mechanism according to a sixth embodiment of this application; and
FIG. 28 is a schematic exploded view of a partial structure of the rotating mechanism shown in FIG. 27.

### DESCRIPTION OF EMBODIMENTS

The following describes embodiments of this application with reference to accompanying drawings in the embodiments of this application.

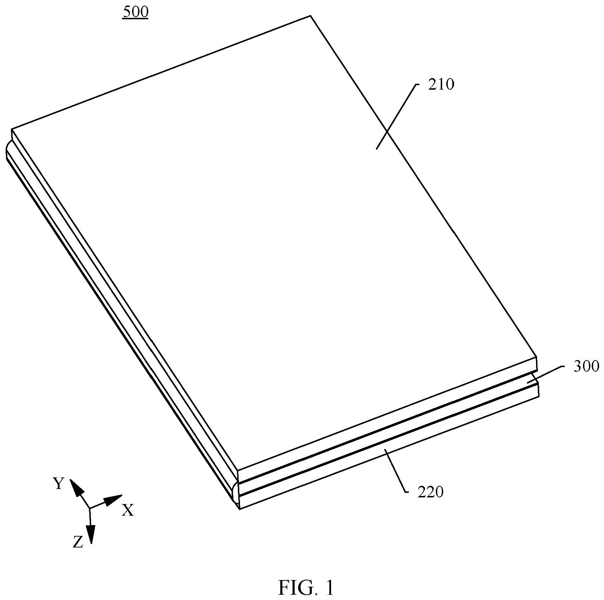

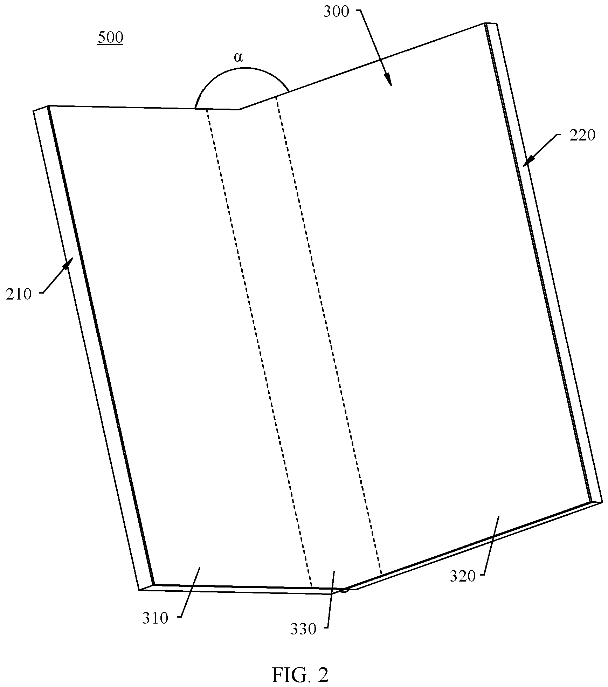

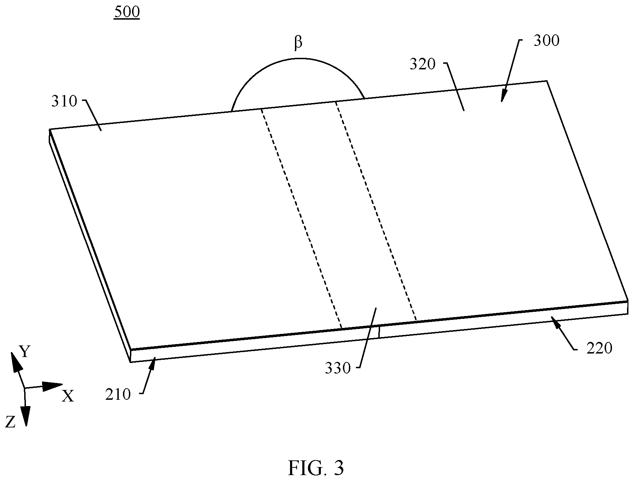

Referring to FIG. 1 to FIG. 3, FIG. 1 is a schematic diagram of a structure of a foldable electronic device 500 in a first state according to an embodiment of this application, FIG. 2 is a schematic diagram of a structure of the foldable electronic device 500 in a second state according to an embodiment of this application, and FIG. 3 is a schematic diagram of a structure of the foldable electronic device 500 in a third state according to an embodiment of this application.

For ease of description, a width direction of the foldable electronic device 500 is defined as an X direction, a length direction of the foldable electronic device 500 is defined as a Y direction, and a thickness direction of the foldable electronic device 500 is defined as a Z direction. The X direction, the Y direction, and the Z direction are perpendicular to each other.

The foldable electronic device 500 includes but is not limited to a cellphone (cellphone), a notebook computer (notebook computer), a tablet personal computer (tablet personal computer), a laptop computer (laptop computer), a personal digital assistant (personal digital assistant), a wearable device (wearable device), a vehicle-mounted device (mobile device), or the like. In this embodiment of this application, an example in which the foldable electronic device 500 is a cellphone is used for description.

The foldable electronic device 500 shown in FIG. 1 is in a folded state, the foldable electronic device 500 shown in FIG. 2 is in a half unfolded state, and the foldable electronic device 500 shown in FIG. 3 is in a fully unfolded state. An unfolding angle α of the foldable electronic device 500 shown in FIG. 2 is 90 degrees, and an unfolding angle β of the foldable electronic device 500 shown in FIG. 3 is 180 degrees.

It should be noted that the angles exemplified in this embodiment of this application are allowed to have slight deviations. For example, that the unfolding angle α of the foldable electronic device 500 shown in FIG. 2 is 90 degrees means that α may be 90 degrees, or may be approximately 90 degrees, for example, 80 degrees, 85 degrees, 95 degrees, or 100 degrees. That the unfolding angle β of the foldable electronic device 500 shown in FIG. 3 is 180 degrees means that β may be 180 degrees, or may be approximately 180 degrees, for example, 170 degrees, 175 degrees, 185 degrees, and 190 degrees. Angles exemplified later may be understood in the same way.

The foldable electronic device 500 shown in this embodiment of this application is an electronic device that can be folded once. In some other embodiments, the foldable electronic device 500 may alternatively be an electronic device that can be folded a plurality of times (at least twice). In this case, the foldable electronic device 500 may include a plurality of parts, two adjacent parts may be folded toward each other until the foldable electronic device 500 is in the folded state, and two adjacent parts may be unfolded away from each other until the foldable electronic device 500 is in the fully unfolded state.

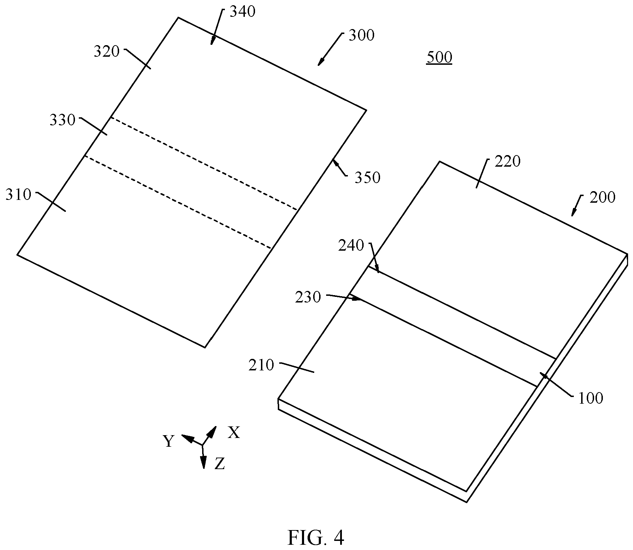

Referring to FIG. 4, FIG. 4 is a schematic exploded view of a structure of the foldable electronic device 500 shown in FIG. 3.

The foldable electronic device 500 includes a foldable apparatus 200 and a display 300, and the display 300 is installed on the foldable apparatus 200. The display 300 includes a display surface 340 and an installation surface 350, and the display surface 340 and the installation surface 350 are disposed opposite to each other. The display surface 340 is configured to display text, an image, a video, and the like. The display 300 includes a first part 310, a second part 320, and a foldable part 330. The foldable part 330 is located between the first part 310 and the second part 320, and the foldable part 330 may be bent in the Y direction. The first part 310, the second part 320, and the foldable part 330 jointly constitute the display 300. In this embodiment, the display 300 is a flexible display, for example, an organic light-emitting diode (organic light-emitting diode, OLED) display, an active-matrix organic light-emitting diode (active-matrix organic light-emitting diode, AMOLED) display, a mini organic light-emitting diode (mini organic light emitting diode) display, a micro light-emitting diode (micro organic light-emitting diode) display, a micro organic light-emitting diode (micro organic light-emitting diode) display, or a quantum dot light-emitting diode (quantum dot light emitting diodes, QLED) display.

The foldable apparatus 200 includes a first housing 210, a second housing 220, and a rotating mechanism 100. A first accommodation groove 230 is disposed in the first housing 210, a second accommodation groove 240 is disposed in the second housing 220, and the first accommodation groove 230 communicates with the second accommodation groove 240 to form an accommodation groove of the rotating mechanism 100. The rotating mechanism 100 is installed in the accommodation groove, and is fixedly connected to the first housing 210 and the second housing 220, to implement a rotary connection between the first housing 210 and the second housing 220. The display 300 is installed on the foldable apparatus 200, and the installation surface 350 is fixedly connected to the foldable apparatus 200. Specifically, the first housing 210 bears the first part 310 of the display 300, and the second housing 220 bears the second part 320. In other words, the first part 310 is installed on the first housing 210, and the second part 320 is installed on the second housing 220. The rotating mechanism 100 and the foldable part 330 are disposed opposite to each other. The first housing 210 and the second housing 220 are capable of rotating relative to each other by using the rotating mechanism 100, so that the foldable apparatus 200 can switch between the folded state and the fully unfolded state.

With reference to FIG. 1, the first housing 210 and the second housing 220 rotate relative to each other by using the rotating mechanism 100, and the first housing 210 and the second housing 220 approach each other to drive the display 300 to be folded, so that the foldable electronic device 500 is folded. When the foldable electronic device 500 is in the folded state, the foldable part 330 of the display 300 is bent, and the first part 310 and the second part 320 are disposed opposite to each other. In this case, the display 300 is located between the first housing 210 and the second housing 220, so that a probability of damage to the display 300 can be greatly reduced, thereby effectively protecting the display 300.

Referring to FIG. 2 and FIG. 4 together, the first housing 210 and the second housing 220 rotate relative to each other by using the rotating mechanism 100, and the first housing 210 and the second housing 220 move away from each other to drive the display 300 to be unfolded, so that the foldable electronic device 500 is unfolded to the half unfolded state. When the foldable electronic device 500 is in the half unfolded state, the first housing 210 and the second housing 220 are unfolded to the included angle α, and the first part 310 and the second part 320 are unfolded relative to each other and drive the foldable part 330 to be unfolded. In this case, an included angle between the first part 310 and the second part 320 is α. In this embodiment, α is 90 degrees. In another embodiment, α may alternatively be approximately 90 degrees, and may be 80 degrees, 85 degrees, 95 degrees, 100 degrees, or the like.

Referring to FIG. 3 and FIG. 4 together, the first housing 210 and the second housing 220 rotate relative to each other by using the rotating mechanism 100, and the first housing 210 and the second housing 220 move away from each other to drive the display 300 to be further unfolded until the foldable electronic device 500 is fully unfolded. When the foldable apparatus 200 is in the fully unfolded state, an included angle between the first housing 210 and the second housing 220 is β. The foldable part 330 is unfolded, and the first part 310 and the second part 320 are unfolded relative to each other. In this case, both included angles between the first part 310 and the second part 320 and the foldable part 330 are β, and the display 300 has a large-area display region, to implement large-screen display of the foldable electronic device 500, thereby improving use experience of a user. In this embodiment, β is 180 degrees. In another embodiment, β may alternatively be approximately 180 degrees, and may be 170 degrees, 175 degrees, 185 degrees, 190 degrees, and the like.

It should be noted that both the included angle α and the included angle β are included angles between the first housing 210 and the second housing 220, and are merely intended herein to distinguish between different angles between the first housing 210 and the second housing 220 when the foldable electronic device 500 is in different states. The included angle α is an angle between the first housing 210 and the second housing 220 when the foldable electronic device 500 is in the half unfolded state. The included angle β is an angle between the first housing 210 and the second housing 220 when the foldable electronic device 500 is in the fully unfolded state.

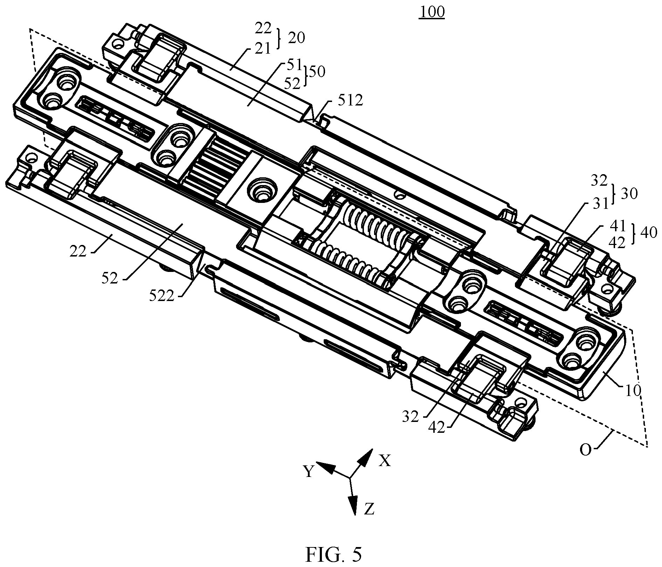

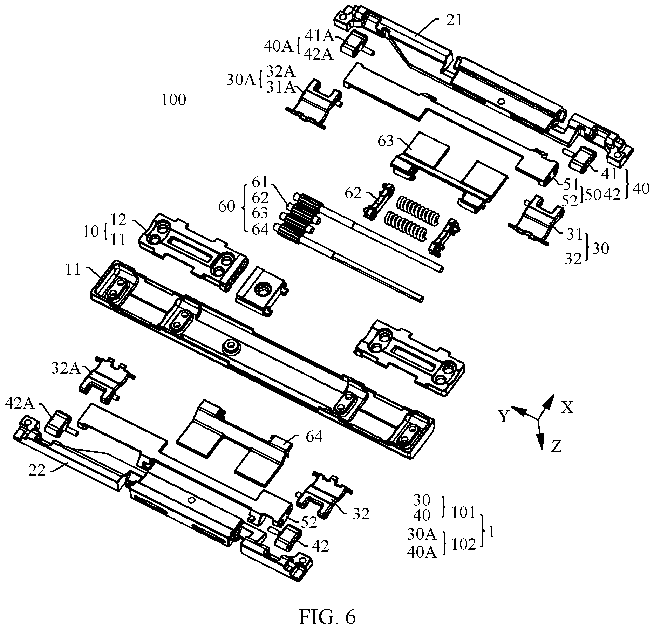

Referring to FIG. 5 and FIG. 6, FIG. 5 is a schematic diagram of a structure of the rotating mechanism 100 in the foldable electronic device 500 shown in FIG. 4, and FIG. 6 is a schematic exploded view of a structure of the rotating mechanism 100 shown in FIG. 5.

For ease of description, a symmetry axis O is set in this application (as shown in FIG. 5). The symmetry axis O is perpendicular to the X direction, the symmetry axis O passes through a center of the rotating mechanism 100, and the rotating mechanism 100 is symmetrical about the symmetry axis O.

The rotating mechanism 100 includes a fixed base 10, a swing arm assembly 1, a synchronization assembly 60, a fastening frame 20, and a pressing plate 50. The swing arm assembly 1 is installed on the fixed base 10, and is rotatably and slidably connected to the fixed base 10. In addition, the swing arm assembly 1 is further rotatably connected to the fastening frame 20. The pressing plate 50 is installed on the fastening frame 20, and is slidably connected to the fastening frame 20, and the pressing plate 50 is rotatably and slidably connected to the swing arm assembly 1. The synchronization assembly 60 is installed on the fixed base 10, and is capable of rotating relative to the fixed base 10, and the synchronization assembly 60 is slidably connected to the fastening frame 20. When rotating relative to the fixed base 10, the fastening frame 20 drives the swing arm assembly 1, the synchronization assembly 60, and the pressing plate 50 to rotate relative to the fixed base 10, so that the rotating mechanism 100 rotates, and the rotating mechanism 100 switches between the folded state and the fully unfolded state.

The fastening frame 20 includes a first fastening frame 21 and a second fastening frame 22. The first fastening frame 21 and the second fastening frame 22 are respectively located on two opposite sides of the fixed base 10 in the X direction. In this embodiment, the first fastening frame 21 is fixedly connected to the first housing 210, and the second fastening frame 22 is fixedly connected to the second housing 220. The pressing plate 50 includes a first pressing plate 51 and a second pressing plate 52. The first pressing plate 51 and the second pressing plate 52 are respectively located on the two opposite sides of the fixed base 10 in the X direction, the first pressing plate 51 is rotatably and slidably connected to the first fastening frame 21, and the second pressing plate 52 is rotatably and slidably connected to the second fastening frame 22.

In this embodiment, there are two swing arm assemblies 1. The two swing arm assemblies 1 are respectively a first swing arm assembly 101 and a second swing arm assembly 102. The first swing arm assembly 101 and the second swing arm assembly 102 are sequentially spaced apart in the Y direction. The first swing arm assembly 101 is located on a side of a Y-axis positive direction of the fixed base 10, and the second swing arm assembly 102 is located on a side of a Y-axis negative direction of the fixed base 10. In another embodiment, there may be one, three, or at least four swing arm assemblies 1. A quantity of swing arm assemblies 1 is not specifically limited in this application.

The first swing arm assembly 101 includes a main swing arm 30 and an intermediate swing arm 40. The main swing arm 30 includes a first main swing arm 31 and a second main swing arm 32, and the intermediate swing arm 40 includes a first intermediate swing arm 41 and a second intermediate swing arm 42. The first main swing arm 31 and the second main swing arm 32 are respectively located on the two opposite sides of the fixed base 10 in the X direction, and are rotatably and slidably connected to the fixed base 10. The first intermediate swing arm 41 is rotatably connected to the first main swing arm 31, and is rotatably connected to the first fastening frame 21. The first intermediate swing arm 41 and the first main swing arm 31 are further rotatably and slidably connected to the first pressing plate 51. The second intermediate swing arm 42 is rotatably connected to the second main swing arm 32, and is rotatably connected to the second fastening frame 22. The second intermediate swing arm 42 and the second main swing arm 32 are further rotatably and slidably connected to the second pressing plate 52.

The second swing arm assembly 102 and the first swing arm assembly 101 may be same or similar assemblies in terms of structure, or may be of structures symmetrical or partially symmetrical to each other or of different structures. In this embodiment, the second swing arm assembly 102 includes a main swing arm 30A and an intermediate swing arm 40A. The main swing arm 30A includes a first main swing arm 31A and a second main swing arm 32A. The intermediate swing arm 40A includes a first intermediate swing arm 41A and a second intermediate swing arm 42A. For basic structures of components in the second swing arm assembly 102, a connection relationship between the components, and a connection relationship between the components and a component outside the assembly, reference may be made to a related design of the first swing arm assembly 101. The second swing arm assembly 102 and the first swing arm assembly 101 may be the same or different in detail structures or position arrangement of components. This is not specifically limited in this application.

When rotating relative to the fixed base 10, the first fastening frame 21 drives the first intermediate swing arm 41 to rotate, to drive the first main swing arm 31 to rotate and slide relative to the fixed base 10. In addition, when rotating relative to the fixed base 10, the first fastening frame 21 further drives the first pressing plate 51 to rotate relative to the fixed base 10. When rotating relative to the fixed base 10, the second fastening frame 22 drives the second intermediate swing arm 42 to rotate, to drive the second main swing arm 32 to rotate and slide relative to the fixed base 10. In addition, when rotating relative to the fixed base 10, the second fastening frame 22 further drives the second pressing plate 52 to rotate relative to the fixed base 10.

The synchronization assembly 60 is installed on the fixed base 10, and is slidably connected to the fastening frame 20. In this embodiment, there is one synchronization assembly 60. In another embodiment, there may alternatively be two or at least three synchronization assemblies 60. The synchronization assembly 60 includes a synchronization member 61, a damping member 62, a first synchronization swing arm 63, and a second synchronization swing arm 64. Both the synchronization member 61 and the damping member 62 are installed in the fixed base 10. The synchronization swing arm is hinged to the damping member 62, and is rotatably connected to the synchronization member 61. The first synchronization swing arm 63 and the second synchronization swing arm 64 are respectively located on the two opposite sides of the fixed base 10 in the X direction, the first synchronization swing arm 63 is slidably connected to the first fastening frame 21, and the second synchronization swing arm 64 is slidably connected to the second fastening frame 22. When rotating relative to the fixed base 10, the first fastening frame 21 drives the first synchronization swing arm 63 to rotate, and generates an acting force on the damping member 62, so that the damping member 62 generates a damping force. In addition, the first synchronization swing arm 63 rotates to drive the synchronization member 61 to rotate, and the synchronization member 61 drives the second synchronization swing arm 64 to rotate, to drive the second fastening frame 22 to rotate, so that synchronous rotation of the rotating mechanism 100 is implemented. In a rotation process of the foldable electronic device 500, the damping member 62 can provide a damping force, so that the user experiences a relatively good damping hand feel, thereby improving use experience of the user. When the damping force reaches a specific value, the foldable electronic device 500 further hovers at a preset angle.

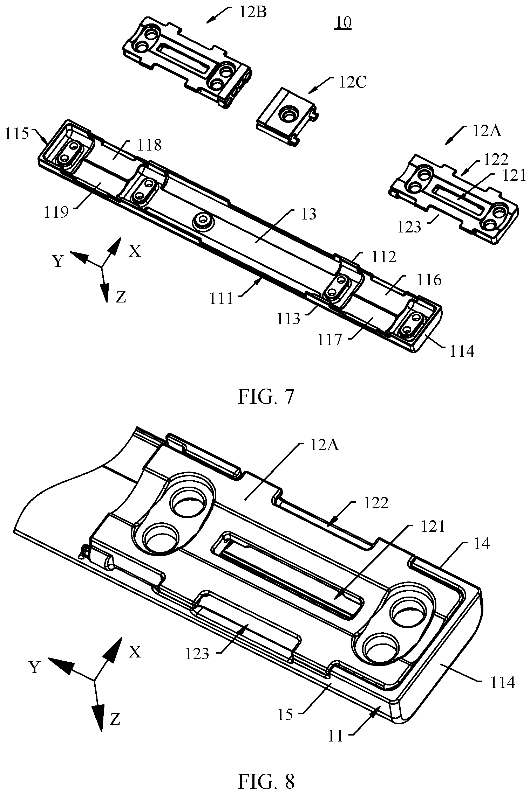

Referring to FIG. 7 and FIG. 8, FIG. 7 is a schematic exploded view of a structure of the fixed base 10 in the rotating mechanism 100 shown in FIG. 6, and FIG. 8 is a schematic diagram of a partially enlarged structure of the fixed base 10 shown in FIG. 7.

The fixed base 10 includes a lower housing 11 and an upper housing 12. The lower housing 11 includes a bottom plate 111, a first side plate 112, a second side plate 113, a first end plate 114, and a second end plate 115. The first side plate 112 and the second side plate 113 are located on two opposite sides of the bottom plate 111 in the X direction, and are fixedly connected to the bottom plate 111. The first end plate 114 and the second end plate 115 are located on two opposite sides of the bottom plate 111 in the Y direction, and are fixedly connected to the bottom plate 111, and the first end plate 114 and the second end plate 115 are connected between the first side plate 112 and the second side plate 113.

The bottom plate 111 is provided with a first rotating groove 116 and a second rotating groove 117. The first rotating groove 116 and the second rotating groove 117 are disposed side by side in the X direction, and the first rotating groove 116 and the second rotating groove 117 are axially symmetrical about the symmetry axis O. Bottom walls of the first rotating groove 116 and the second rotating groove 117 are arc-shaped. The first rotating groove 116 extends toward the first side plate 112, and the second rotating groove 117 extends toward the second side plate 113. The first rotating groove 116 is configured to install the first main swing arm 31 in the first swing arm assembly 101, and the first main swing arm 31 is capable of rotating and sliding along the first rotating groove 116. The second rotating groove 117 is configured to install the second main swing arm 32 in the first swing arm assembly 101, and the second main swing arm 32 is capable of rotating and sliding along the second rotating groove 117.

The bottom plate 111 is further provided with a third rotating groove 118 and a fourth rotating groove 119. The third rotating groove 118 and the fourth rotating groove 119 are disposed side by side in the X direction, and the third rotating groove 118 and the fourth rotating groove 119 are axially symmetrical about the symmetry axis O. The third rotating groove 118 and the first rotating groove 116 are disposed side by side and spaced apart in the Y direction, and the third rotating groove 118 is located in a Y-axis positive direction of the first rotating groove 116. The fourth rotating groove 119 and the second rotating groove 117 are disposed side by side in the Y direction, and the fourth rotating groove 119 is located in a Y-axis positive direction of the second rotating groove 117. The third rotating groove 118 is configured to install the first main swing arm 31Ain the second swing arm assembly 102, and the first main swing arm 31Ais capable of rotating and sliding along the third rotating groove 118. The fourth rotating groove 119 is configured to install the second main swing arm 32A in the second swing arm assembly 102, and the second main swing arm 32Ais capable of rotating and sliding along the fourth rotating groove 119.

The upper housing 12 includes a first sub-housing 12A, a second sub-housing 12B, and a third sub-housing 12C. The first sub-housing 12A is provided with a first avoidance hole 121, a first opening 122, and a second opening 123. The first opening 122 and the second opening 123 are respectively located on two opposite sides of the first sub-housing 12A in the X direction, the first avoidance hole 121 is located between the first opening 122 and the second opening 123, and is spaced apart from the first opening 122 and the second opening 123, and the first avoidance hole 121 runs through the first sub-housing 12A in the Z direction.

The first sub-housing 12A is located at an end of a Y-axis negative direction of the lower housing 11, is disposed opposite to the first rotating groove 116 and the second rotating groove 117, and is fixedly connected to the lower housing 11. The first opening 122 is located at an end portion of the first rotating groove 116, and communicates with the first rotating groove 116. The second opening 123 is located at an end portion of the second rotating groove 117, and communicates with the second rotating groove 117. The first opening 122 is used for the first main swing arm 31 to pass through, so that the first main swing arm 31 is installed in the first rotating groove 116. The second opening 123 is used for the second main swing arm 32 to pass through, so that the second main swing arm 32 is installed in the second rotating groove 117. The first avoidance hole 121 is configured to avoid the first main swing arm 31 and the second main swing arm 32. In this embodiment, the first sub-housing 12A is fixedly connected to the lower housing 11 through bolts. In another embodiment, the first sub-housing 12A may alternatively be fixedly connected to the lower housing 11 through glue, welding, or the like.

A structure of the second sub-housing 12B is the same as a structure of the first sub-housing 12A. The second sub-housing 12B is located at an end of a Y-axis positive direction of the lower housing 11, and is disposed opposite to the third rotating groove 118 and the fourth rotating groove 119. The third sub-housing 12C is located between the first sub-housing 12A and the second sub-housing 12B, and is fixedly connected to the lower housing 11. The third sub-housing 12C is configured to be rotatably connected to the synchronization assembly 60.

The fixed base 10 is further provided with an installation groove 13. The installation groove 13 is disposed on the bottom plate 111 of the lower housing 11, and is located between the first sub-housing 12A and the third sub-housing 12C. The installation groove 13 is configured to install the synchronization assembly 60. The fixed base 10 further includes a first side 14 and a second side 15, and the first side 14 and the second side 15 are disposed opposite to each other, and are respectively located on the two opposite sides of the fixed base 10 in the X direction.

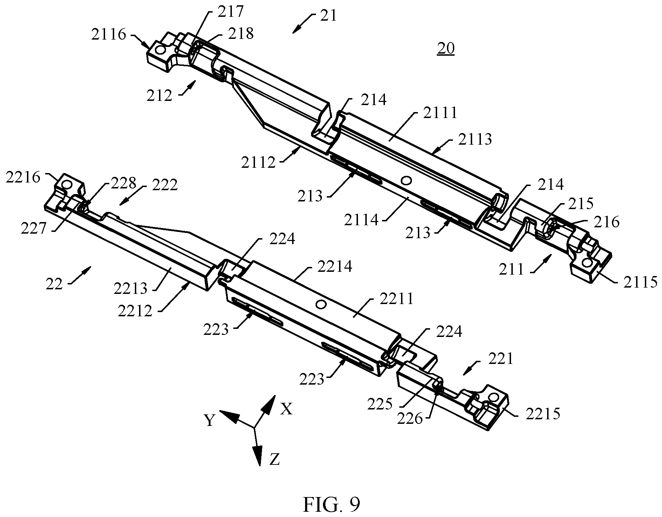

Referring to FIG. 9, FIG. 9 is a schematic diagram of an enlarged structure of the fastening frame 20 in the rotating mechanism 100 shown in FIG. 6.

The fastening frame 20 includes the first fastening frame 21 and the second fastening frame 22. The first fastening frame 21 is a strip-shaped wedge block with a thickness. The first fastening frame 21 includes a first upper surface 2111, a first lower surface 2112, a first side surface 2113, a second side surface 2114, a first end surface 2115, and a second end surface 2116. The first upper surface 2111 is disposed opposite to the first lower surface 2112, the first side surface 2113 is disposed opposite to the second side surface 2114, and the first end surface 2115 is disposed opposite to the second end surface 2116. Both the first side surface 2113 and the second side surface 2114 are connected between the first upper surface 2111 and the first lower surface 2112, and both the first end surface 2115 and the second end surface 2116 are connected between the first side surface 2113 and the second side surface 2114.

The first fastening frame 21 is provided with a first notch 211, a second notch 212, a first sliding groove 213, and a first guide groove 214. Both the first notch 211 and the second notch 212 are disposed on the second side surface 2114, and both the first notch 211 and the second notch 212 run through the first upper surface 2111 and the first lower surface 2112. A first shaft sleeve 215 is fastened to an inner wall of the first notch 211. The first shaft sleeve 215 is provided with a first rotating hole 216. A pivot extension direction of the first rotating hole 216 is parallel to the Y direction. The first rotating hole 216 is configured to install a rotating shaft, to implement a rotary connection to the first intermediate swing arm 41 in the first swing arm assembly 101. The second notch 212 is symmetrical to the first notch 211, and the second notch 212 is located at an end of a Y-axis negative direction of the first fastening frame 21. A second shaft sleeve 217 is fastened to an inner wall of the second notch 212. The second shaft sleeve 217 is provided with a second rotating hole 218. The second rotating hole 218 is configured to install a rotating shaft, to implement a rotary connection to the first intermediate swing arm 41A in the second swing arm assembly 102.

In this embodiment, there are two first guide grooves 214. The two first guide grooves 214 are arc-shaped, are recessed in the first upper surface 2111, and run through the first side surface 2113. The two first guide grooves 214 are disposed between the first notch 211 and the second notch 212, and are spaced apart in the Y direction. The two first guide grooves 214 are configured to be slidably connected to the first pressing plate 51. In another embodiment, there may alternatively be one or at least three first guide grooves 214. A quantity of first guide grooves 214 is not limited herein, provided that when there are a plurality of first guide grooves 214, the plurality of first guide grooves 214 are spaced apart in the Y direction.

In this embodiment, there are two first sliding grooves 213. The two first sliding grooves 213 are located between the two first guide grooves 214, and are spaced apart in the Y direction. The two first sliding grooves 213 run through the first side surface 2113 and the second side surface 2114. The two first sliding grooves 213 are configured to be slidably connected to the first synchronization swing arm 63 in the synchronization assembly 60. In another embodiment, there may alternatively be one or at least three first sliding grooves 213. A quantity of first sliding grooves 213 is not limited herein, provided that when there are a plurality of first sliding grooves 213, the plurality of first sliding grooves 213 are spaced apart in the Y direction.

In this embodiment, the second fastening frame 22 and the first fastening frame 21 are of structures mirror-symmetrical to each other, and the second fastening frame 22 and the first fastening frame 21 are axially symmetrical about the symmetry axis O. The second fastening frame 22 includes a second upper surface 2211, a second lower surface 2212, a third side surface 2213, a fourth side surface 2214, a third end surface 2215, and a fourth end surface 2216 that form an outer surface of the second fastening frame 22 through enclosure. The second fastening frame 22 is provided with a third notch 221, a fourth notch 222, two second sliding grooves 223, and two second guide grooves 224. A structure of the third notch 221 is the same as a structure of the first notch 211, and an inner wall of the third notch 221 is provided with a third shaft sleeve 225. The third shaft sleeve 225 is provided with a third rotating hole 226. The third rotating hole 226 is configured to install a rotating shaft, to implement a rotary connection to the second intermediate swing arm 42 in the first swing arm assembly 101. An inner wall of the fourth notch 222 is provided with a fourth shaft sleeve 227. The fourth shaft sleeve 227 is provided with a fourth rotating hole 228. The fourth rotating hole 228 is configured to install a rotating shaft, to implement a rotary connection to the second intermediate swing arm 42A in the second swing arm assembly 102. A structure of the second guide groove 224 is the same as a structure of the first guide groove 214, and the second guide groove 224 is configured to be slidably connected to the second pressing plate 52. A structure of the second sliding groove 223 is the same as a structure of the first sliding groove 213, and the second sliding grooves 223 are configured to be slidably connected to the second synchronization swing arm 64 in the synchronization assembly 60. In another embodiment, a structure of the second fastening frame 22 may alternatively be different from a structure of the first fastening frame 21, provided that the structure of the second fastening frame 22 can be adapted to the swing arm assembly 1, the synchronization assembly 60, and the pressing plate 50.

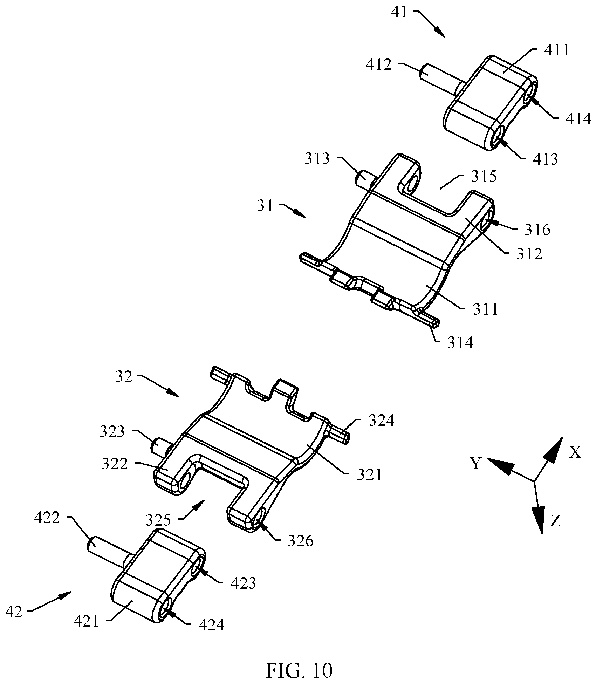

Referring to FIG. 10, FIG. 10 is a schematic diagram of an enlarged structure of the first swing arm assembly 101 in the rotating mechanism 100 shown in FIG. 6.

The first swing arm assembly 101 includes the main swing arm 30 and the intermediate swing arm 40. The main swing arm 30 includes the first main swing arm 31 and the second main swing arm 32. The first main swing arm 31 includes a first rotating body 311, a first swing body 312, a first shaft body 313, and a first stop block 314. The first rotating body 311 is of an arc-shaped plate-like structure. A structure of the first rotating body 311 matches a structure of the first rotating groove 116, and the first rotating body 311 is capable of sliding and rotating in the first rotating groove 116. An end of the first swing body 312 is provided with a first avoidance notch 315 and a first shaft hole 316. The first shaft hole 316 runs through the first swing body 312 in the Y direction, and communicates with the first avoidance notch 315. An end that is of the first swing body 312 and that faces away from the first avoidance notch 315 is fixedly connected to the first rotating body 311. The first shaft body 313 is fixedly connected to a side surface of the first swing body 312, and is spaced apart from the first shaft hole 316. An extension direction of the first shaft body 313 is parallel to the Y direction. The first shaft body 313 is configured to be rotatably connected to the first pressing plate 51. The first stop block 314 is fastened to an end that is of the first rotating body 311 and that faces away from the first swing body 312, and extends away from a side surface of the first rotating body 311 in the Y direction. In this embodiment, the first stop block 314 has a stopping function. When the rotating mechanism 100 is in the folded state, the first stop block 314 abuts against an inner wall of the fixed base 10, so that the first main swing arm 31 can be prevented from sliding out of the fixed base 10 when the first main swing arm 31 slides in the first rotating groove 116, thereby improving sliding stability of the first main swing arm 31. The first main swing arm 31 is installed in the first rotating groove 116, and is configured to be rotatably and slidably connected to the fixed base 10.

The second main swing arm 32 has a same structure as the first main swing arm 31. The second main swing arm 32 includes a second rotating body 321, a second swing body 322, a third shaft body 323, and a second stop block 324. A structure of the second rotating body 321 is the same as the structure of the first rotating body 311. A structure of the second swing body 322 is the same as a structure of the first swing body 312. An end of the second swing body 322 is provided with a second avoidance notch 325 and a second shaft hole 326. The second shaft hole 326 runs through the second swing body 322 in the Y direction, and communicates with the second avoidance notch 325. An end that is of the second swing body 322 and that faces away from the second avoidance notch 325 is fixedly connected to the second rotating body 321. A structure of the third shaft body 323 is the same as a structure of the first shaft body 313, and the third shaft body 323 is configured to be rotatably connected to the second pressing plate 52. A structure of the second stop block 324 is the same as a structure of the first stop block 314. In this embodiment, disposing the second stop block 324 can prevent the second main swing arm 32 from sliding out of the fixed base 10 when the second main swing arm 32 slides in the second rotating groove 117. The second main swing arm 32 is installed in the second rotating groove 117 of the fixed base 10, and is configured to be rotatably and slidably connected to the fixed base 10.

The intermediate swing arm 40 includes the first intermediate swing arm 41 and the second intermediate swing arm 42. The first intermediate swing arm 41 includes a first body 411 and a second shaft body 412. The first body 411 is provided with a third shaft hole 413 and a fourth shaft hole 414. The third shaft hole 413 and the fourth shaft hole 414 are disposed side by side and spaced apart in the X direction. Extension directions of the third shaft hole 413 and the fourth shaft hole 414 are parallel to the Y direction, and the third shaft hole 413 and the fourth shaft hole 414 run through the first body 411 in the Y direction. The second shaft body 412 is fastened to a side surface of the first body 411, is located between the third shaft hole 413 and the fourth shaft hole 414, and is spaced apart from the third shaft hole 413 and the fourth shaft hole 414. In addition, an extension direction of the second shaft body 412 is parallel to the Y direction. The third shaft hole 413 is configured to be rotatably connected to the first main swing arm 31, the fourth shaft hole 414 is configured to be rotatably connected to the first fastening frame 21, and the second shaft body 412 is configured to be rotatably connected to the first pressing plate 51.

A structure of the second intermediate swing arm 42 is the same as a structure of the first intermediate swing arm 41. The second intermediate swing arm 42 includes a second body 421 and a fourth shaft body 422. A structure of the second body 421 is the same as a structure of the first body 411. The second body 421 is provided with a fifth shaft hole 423 and a sixth shaft hole 424. The fifth shaft hole 423 is configured to be rotatably connected to the second main swing arm 32, and the sixth shaft hole 424 is configured to be rotatably connected to the second fastening frame 22. A structure of the fourth shaft body 422 is the same as a structure of the second shaft body 412, and the fourth shaft body 422 is configured to be rotatably connected to the second pressing plate 52.

A structure of the main swing arm 30A in the second swing arm assembly 102 is the same as or similar to a structure of the main swing arm 30 in the first swing arm assembly 101, and a structure of the intermediate swing arm 40A in the second swing arm assembly 102 is the same as or similar to a structure of the intermediate swing arm 40 in the first swing arm assembly 101. Details are not described herein again.

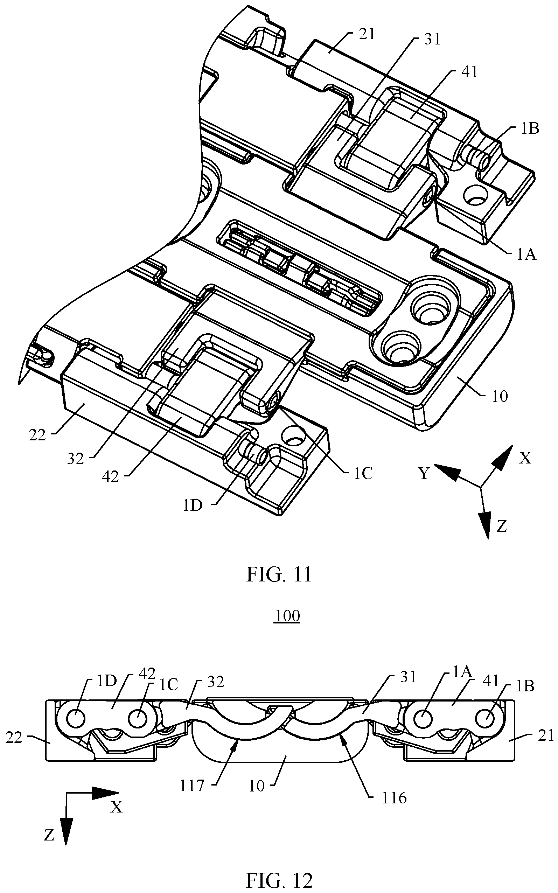

Referring to FIG. 11 together, FIG. 11 is a schematic diagram of a partial structure of the rotating mechanism 100 shown in FIG. 5 in the fully unfolded state.

The rotating mechanism 100 further includes a first rotating shaft 1A, a second rotating shaft 1B, a third rotating shaft 1C, and a fourth rotating shaft 1D. The first rotating shaft 1A is configured to enable the first main swing arm 31 to be rotatably connected to the first intermediate swing arm 41, the second rotating shaft 1B is configured to enable the first intermediate swing arm 41 to be rotatably connected to the first fastening frame 21, the third rotating shaft 1C is configured to enable the second main swing arm 32 to be rotatably connected to the second intermediate swing arm 42, and the fourth rotating shaft 1D is configured to enable the second intermediate swing arm 42 to be rotatably connected to the second fastening frame 22.

The first fastening frame 21, the first main swing arm 31, and the first intermediate swing arm 41 are located on one side of the fixed base 10, to be specific, are located in an X-axis positive direction, and the second fastening frame 22, the second main swing arm 32, and the second intermediate swing arm 42 are located on the other side of the fixed base 10, to be specific, are located in an X-axis negative direction. The first rotating body 311 of the first main swing arm 31 is installed in the first rotating groove 116, and the first rotating body 311 is capable of sliding and rotating in the first rotating groove 116. A part of the first body 411 of the first intermediate swing arm 41 is located in the first avoidance notch 315, the third shaft hole 413 is aligned with the first shaft hole 316, and axes of the third shaft hole 413 and the first shaft hole 316 are on a same straight line. The first rotating shaft 1A passes through the first shaft hole 316 and the third shaft hole 413. In this embodiment, the first rotating shaft 1A is fixedly connected to an inner wall of the first shaft hole 316, and is capable of rotating in the third shaft hole 413. In this embodiment, the first rotating shaft 1A may alternatively be fixedly connected to an inner wall of the third shaft hole 413, and is capable of rotating in the first shaft hole 316. An end that is of the first intermediate swing arm 41 and that faces away from the first main swing arm 31 is located in the first notch 211 of the first fastening frame 21, the fourth shaft hole 414 is aligned with the first rotating hole 216, and axes of the fourth shaft hole 414 and the first rotating hole 216 are on a same straight line. The second rotating shaft 1B passes through the first rotating hole 216 and the fourth shaft hole 414. In this embodiment, the second rotating shaft 1B is fixedly connected to an inner wall of the first rotating hole 216, and is capable of rotating in the fourth shaft hole 414. In another embodiment, the second rotating shaft 1B may alternatively be fixedly connected to an inner wall of the fourth shaft hole 414, and is capable of rotating in the first rotating hole 216.

The second rotating body 321 of the second main swing arm 32 is installed in the second rotating groove 117, and the second rotating body 321 is capable of sliding and rotating in the second rotating groove 117. A part of the second body 421 of the second intermediate swing arm 42 is located in the second avoidance notch 325, the fifth shaft hole 423 is aligned with the second shaft hole 326, and axes of the fifth shaft hole 423 and the second shaft hole 326 are on a same straight line. The third rotating shaft 1C passes through the fifth shaft hole 423 and the second shaft hole 326. In this embodiment, the third rotating shaft 1C is fixedly connected to an inner wall of the second shaft hole 326, and is capable of rotating in the fifth shaft hole 423. In another embodiment, the third rotating shaft 1C may alternatively be fixedly connected to an inner wall of the fifth shaft hole 423, and is capable of rotating in the second shaft hole 326. An end that is of the second intermediate swing arm 42 and that faces away from the second main swing arm 32 is located in the third notch 221 of the second fastening frame 22, the sixth shaft hole 424 is aligned with the third rotating hole 226, and axes of the sixth shaft hole 424 and the third rotating hole 226 are on a same straight line. The fourth rotating shaft 1D passes through the third rotating hole 226 and the sixth shaft hole 424. In this embodiment, the fourth rotating shaft 1D is fixedly connected to an inner wall of the third rotating hole 226, and is capable of rotating in the sixth shaft hole 424. In another embodiment, the fourth rotating shaft 1D may alternatively be fixedly connected to an inner wall of the sixth shaft hole 424, and is capable of rotating in the third rotating hole 226.

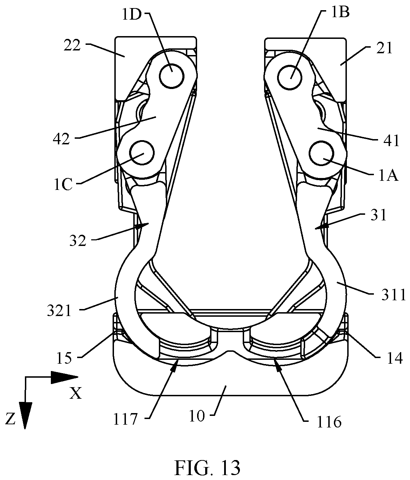

Referring to FIG. 12 and FIG. 13, FIG. 12 is a schematic diagram of a cross-sectional structure of the rotating mechanism 100 shown in FIG. 5 in the fully unfolded state, and FIG. 13 is a schematic diagram of a cross-sectional structure of the rotating mechanism 100 shown in FIG. 12 in the folded state.

When the rotating mechanism 100 is in the fully unfolded state, the first fastening frame 21 and the second fastening frame 22 are unfolded relative to the fixed base 10, the first main swing arm 31 and the second main swing arm 32 are unfolded relative to the fixed base 10, and the first intermediate swing arm 41 and the second intermediate swing arm 42 are unfolded relative to the fixed base 10. The first main swing arm 31 and the first intermediate swing arm 41 are approximately parallel to each other, and the second main swing arm 32 and the second intermediate swing arm 42 are approximately parallel to each other.

When rotating counterclockwise relative to the fixed base 10, the first fastening frame 21 drives the first intermediate swing arm 41 to rotate counterclockwise relative to the fixed base 10, and the first intermediate swing arm 41 drives the first main swing arm 31 to rotate counterclockwise, so that the first rotating body 311 slides away from the fixed base 10 in the first rotating groove 116. In addition, the first intermediate swing arm 41 rotates counterclockwise around the second rotating shaft 1B and the first rotating shaft 1A. In other words, the first intermediate swing arm 41 rotates counterclockwise relative to the first fastening frame 21, and rotates counterclockwise relative to the first main swing arm 31. When rotating clockwise relative to the fixed base 10, the second fastening frame 22 drives the second intermediate swing arm 42 to rotate clockwise relative to the fixed base 10, and the second intermediate swing arm 42 drives the second main swing arm 32 to rotate clockwise, so that the second rotating body 321 slides away from the fixed base 10 in the second rotating groove 117. In addition, the second intermediate swing arm 42 rotates counterclockwise around the fourth rotating shaft 1D and the third rotating shaft 1C. In other words, the second intermediate swing arm 42 rotates clockwise relative to the second fastening frame 22, and rotates clockwise relative to the second main swing arm 32, so that the rotating mechanism 100 rotates to the folded state (as shown in FIG. 13).

When the rotating mechanism 100 is in the folded state, the first fastening frame 21 and the second fastening frame 22 are folded relative to each other, the first main swing arm 31 and the second main swing arm 32 are folded relative to each other, and the first intermediate swing arm 41 and the second intermediate swing arm 42 are folded relative to each other. The first main swing arm 31 is located between the first side 14 and the second side 15, and the first rotating body 311 is located on an inner side of the fixed base 10, to be specific, is located in an X-axis negative direction of the first side 14. The first intermediate swing arm 41 is tilted toward the fixed base 10 relative to the first main swing arm 31, and an included angle between the first intermediate swing arm 41 and the first main swing arm 31 is an obtuse angle. The second main swing arm 32 is located between the first side 14 and the second side 15, and the second rotating body 321 is located on the inner side of the fixed base 10, to be specific, is located in an X-axis positive direction of the second side 15. The second intermediate swing arm 42 is tilted toward the fixed base 10 relative to the second main swing arm 32, and an included angle between the second intermediate swing arm 42 and the second main swing arm 32 is an obtuse angle.

When the rotating mechanism 100 rotates from the folded state to the fully unfolded state, the first fastening frame 21, the first main swing arm 31, and the first intermediate swing arm 41 rotate clockwise relative to the fixed base 10, and the second fastening frame 22, the second main swing arm 32, and the second intermediate swing arm 42 rotate counterclockwise relative to the fixed base 10.

In this embodiment, the first intermediate swing arm 41 is disposed between the first main swing arm 31 and the first fastening frame 21, and when the rotating mechanism 100 rotates from the fully unfolded state to the folded state, the first intermediate swing arm 41 is capable of rotating relative to the first main swing arm 31 and the first fastening frame 21, to compensate for a rotation angle of the first main swing arm 31 relative to the fixed base 10 and optimize a position of a pivot around which the first main swing arm 31 rotates relative to the fixed base 10, thereby reducing the rotation angle of the first main swing arm 31 relative to the fixed base 10. In addition, when the rotating mechanism 100 is in the folded state, the first main swing arm 31 is located between the first side 14 and the second side 15, so that a distance by which the first main swing arm 31 protrudes from a side surface of the fixed base 10 can be reduced, thereby reducing space occupied by the first main swing arm 31 in a thickness direction of the rotating mechanism 100 when the rotating mechanism 100 is in the folded state and reducing a thickness of the rotating mechanism 100 in the folded state. In this way, lightness and thinning of the foldable electronic device 500 are implemented. In addition, the second intermediate swing arm 42 is disposed between the second main swing arm 32 and the second fastening frame 22, and when the rotating mechanism 100 rotates from the fully unfolded state to the folded state, the second intermediate swing arm 42 is capable of rotating relative to the second main swing arm 32 and the second fastening frame 22, to compensate for a rotation angle of the second main swing arm 32 relative to the fixed base 10 and optimize a position of a pivot around which the second main swing arm 32 rotates relative to the fixed base 10, thereby reducing the rotation angle of the second main swing arm 32 relative to the fixed base 10. In addition, when the rotating mechanism 100 is in the folded state, the second main swing arm 32 is located between the first side 14 and the second side 15, so that a distance by which the second main swing arm 32 protrudes from a side surface of the fixed base 10 can be reduced, thereby reducing space occupied by the second main swing arm 32 in the thickness direction of the rotating mechanism 100 when the rotating mechanism 100 is in the folded state and further reducing the thickness of the rotating mechanism 100 in the folded state. In this way, lightness and thinning of the foldable electronic device 500 are implemented.

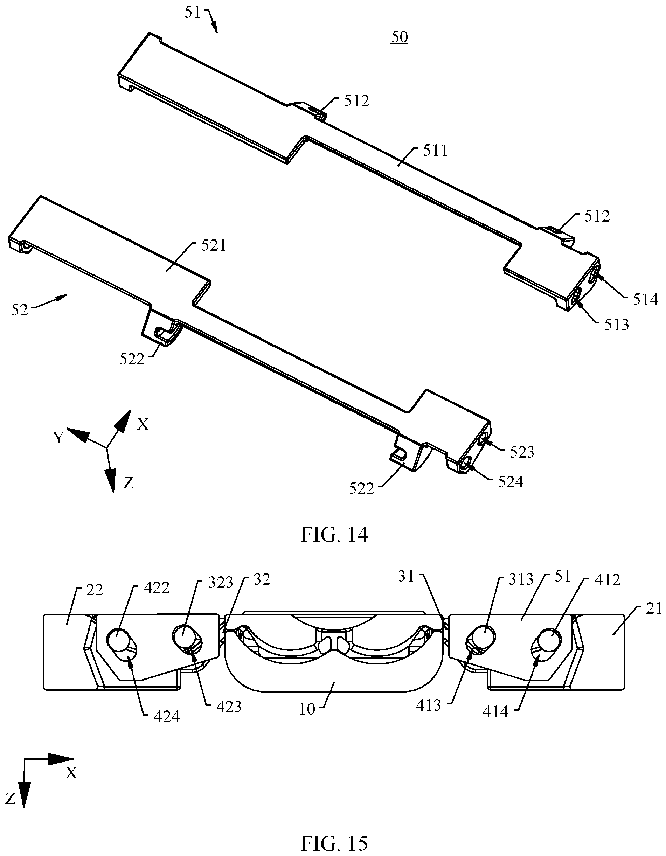

Referring to FIG. 14, FIG. 14 is a schematic diagram of an enlarged structure of the pressing plate 50 in the rotating mechanism 100 shown in FIG. 6.

The pressing plate 50 includes the first pressing plate 51 and the second pressing plate 52. The first pressing plate 51 is rotatably and slidably connected to the first fastening frame 21, and is rotatably connected to the first main swing arm 31 and the first intermediate swing arm 41. The second pressing plate 52 is rotatably and slidably connected to the second fastening frame 22, and is rotatably connected to the second main swing arm 32 and the second intermediate swing arm 42.

The first pressing plate 51 includes a first pressing plate body 511 and a first sliding block 512. The first pressing plate body 511 is strip-shaped. The first pressing plate body 511 is provided with a first sliding hole 513 and a second sliding hole 514. The first sliding hole 513 and the second sliding hole 514 are disposed on an end surface of the first pressing plate body 511 in the Y direction, and the first sliding hole 513 and the second sliding hole 514 are spaced apart in the X direction. Extension directions of the first sliding hole 513 and the second sliding hole 514 intersect the X direction, and the extension directions of the first sliding hole 513 and the second sliding hole 514 are parallel to each other. The first sliding hole 513 is configured to be rotatably and slidably connected to the first main swing arm 31 in the first swing arm assembly 101, and the second sliding hole 514 is configured to be rotatably and slidably connected to the first intermediate swing arm 41 in the first swing arm assembly 101. The first pressing plate body 511 is further provided with a first auxiliary sliding hole and a second auxiliary sliding hole (not marked in the figure). The first auxiliary sliding hole and the second auxiliary sliding hole are disposed on the other end surface of the first pressing plate body 511 in the Y direction. The first auxiliary sliding hole is configured to be rotatably and slidably connected to the first main swing arm 31A in the second swing arm assembly 102, and the second auxiliary sliding hole is configured to be rotatably and slidably connected to the first intermediate swing arm 41A in the second swing arm assembly 102. The first sliding block 512 is fixedly connected to the first pressing plate body 511. In this embodiment, there are two first sliding blocks 512. The two first sliding blocks 512 are spaced apart in the Y direction. Each first sliding block 512 is arc-shaped. A structure of the first sliding block 512 is adapted to the structure of the first guide groove 214, and the first sliding block 512 is capable of sliding and rotating along the first guide groove 214. In another embodiment, there may alternatively be one or at least three first sliding blocks 512. A quantity of first sliding blocks 512 is not limited herein, provided that the quantity of first sliding blocks 512 is consistent with the quantity of first guide grooves 214.

A structure of the second pressing plate 52 is approximately the same as a structure of the first pressing plate 51. The second pressing plate 52 includes a second pressing plate body 521 and a second sliding block 522. One end surface of the second pressing plate body 521 in the Y direction is provided with a third sliding hole 523 and a fourth sliding hole 524, and the other end surface in the Y direction is provided with a third auxiliary sliding hole and a fourth auxiliary sliding hole (not marked in the figure). The third sliding hole 523 is configured to be rotatably and slidably connected to the second main swing arm 32 in the first swing arm assembly 101, and the fourth sliding hole 524 is configured to be rotatably and slidably connected to the second intermediate swing arm 42 in the first swing arm assembly 101. The third auxiliary sliding hole is configured to be rotatably and slidably connected to the second main swing arm 32A in the second swing arm assembly 102, and the fourth auxiliary sliding hole is configured to be rotatably and slidably connected to the second intermediate swing arm 42A in the second swing arm assembly 102. In this embodiment, there are two second sliding blocks 522. A structure of the second sliding block 522 is adapted to the structure of the second guide groove 224, and the second sliding block 522 is capable of sliding and rotating along the second guide groove 224. In another embodiment, there may alternatively be one or at least three second sliding blocks 522. A quantity of second sliding blocks 522 is not limited herein, provided that the quantity of second sliding blocks 522 is consistent with the quantity of first guide grooves 214.

To understand an assembling relationship between the pressing plate 50 and another element more clearly, with reference to FIG. 5 and FIG. 6, the first pressing plate 51 is located in the X-axis positive direction of the fixed base 10, and is stacked with the first fastening frame 21. The first sliding block 512 is installed in the first guide groove 214, and each first sliding block 512 is capable of sliding and rotating in a corresponding first guide groove 214. The first shaft body 313 of the first main swing arm 31 is installed in the first sliding hole 513, and the second shaft body 412 of the first intermediate swing arm 41 is installed in the second sliding hole 514. The second pressing plate 52 is located in the X-axis negative direction of the fixed base 10, and is stacked with the second fastening frame 22. The second sliding block 522 is installed in the second guide groove 224, and each second sliding block 522 is capable of sliding and rotating in the corresponding second guide groove 224. The third shaft body 323 of the second main swing arm 32 is installed in the third sliding hole 523, and the fourth shaft body 422 of the second intermediate swing arm 42 is installed in the fourth sliding hole 524.

Both the first pressing plate 51 and the second pressing plate 52 are disposed opposite to the display 300. The first pressing plate 51 and the second pressing plate 52 jointly support the display 300, so that connection stability of the display 300 can be improved, thereby ensuring good display of the display 300.

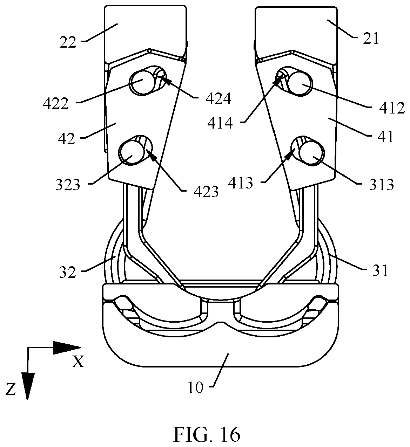

Referring to FIG. 15 and FIG. 16 together, FIG. 15 is a schematic diagram of a cross-sectional structure of the rotating mechanism 100 shown in FIG. 5, and FIG. 16 is a schematic diagram of a cross-sectional structure of the rotating mechanism 100 shown in FIG. 15 in the folded state.

When rotating, the first housing 210 drives the first fastening frame 21 to rotate relative to the fixed base 10, to drive the first pressing plate 51 to rotate relative to the fixed base 10 and enable the first sliding block 512 to slide in an arc shape in a corresponding first guide groove 214, so that the first pressing plate 51 is driven to slide in an arc shape relative to the first fastening frame 21. In addition, when rotating relative to the fixed base 10, the first fastening frame 21 further drives the first intermediate swing arm 41 to rotate relative to the fixed base 10, and enables the second shaft body 412 to rotate and slide in the second sliding hole 514. When rotating relative to the fixed base 10, the first intermediate swing arm 41 drives the first main swing arm 31 to rotate relative to the fixed base 10, and enables the first shaft body 313 to rotate and slide in the first sliding hole 513, so that the first pressing plate 51 rotates relative to the fixed base 10.

When rotating, the second housing 220 drives the second fastening frame 22 to rotate relative to the fixed base 10, to drive the second pressing plate 52 to rotate relative to the fixed base 10 and enable the second sliding block 522 to slide in an arc shape in a corresponding second guide groove 224, so that the second pressing plate 52 is driven to slide in an arc shape relative to the second fastening frame 22. In addition, when rotating relative to the fixed base 10, the second fastening frame 22 further drives the second intermediate swing arm 42 to rotate relative to the fixed base 10, and enables the fourth shaft body 422 to rotate and slide in the fourth sliding hole 524. When rotating relative to the fixed base 10, the second intermediate swing arm 42 drives the second main swing arm 32 to rotate relative to the fixed base 10, and enables the third shaft body 323 to rotate and slide in the third sliding hole 523, so that the second pressing plate 52 rotates relative to the fixed base 10.

In this embodiment, the first housing 210 drives the first fastening frame 21 to rotate, to drive the first pressing plate 51 to rotate, and the second housing 220 drives the second fastening frame 22 to rotate, to drive the second pressing plate 52 to rotate, so that the foldable electronic device 500 switches between the folded state and the fully unfolded state, thereby implementing folding and unfolding of the display 300. In addition, in this embodiment, the first pressing plate 51 is capable of sliding in an arc shape relative to the first fastening frame 21, and the second pressing plate 52 is capable of sliding in an arc shape related to the second fastening frame 22, so that an included angle between the first pressing plate 51 and the second pressing plate 52 can be adjusted, to adapt to a folding angle of the foldable part 330 of the display 300, thereby preventing the first pressing plate 51 and the second pressing plate 52 from squeezing the display 300 when the rotating mechanism 100 is in the folded state. In other words, when the rotating mechanism 100 is in the folded state, an included angle between the first fastening frame 21 and the second fastening frame 22 is different from the included angle between the first pressing plate 51 and the second pressing plate 52, and the included angle between the first pressing plate 51 and the second pressing plate 52 can be adjusted based on a bending angle of the display 300, to adapt to bending of the display 300.

In this embodiment, the first pressing plate 51 is slidably and rotatably connected to the first main swing arm 31 and the first intermediate swing arm 41, so that the first pressing plate 51 can rotate relative to the fixed base 10 at the same time as the first main swing arm 31 and the first intermediate swing arm 41, thereby implementing rotation of the first pressing plate 51 relative to the fixed base 10. In this way, stability of rotation of the first pressing plate 51 can be improved. In addition, a pressing plate swing arm can be saved, in other words, in this embodiment, stable rotation of the first pressing plate 51 can be implemented without the pressing plate swing arm, so that a structure of the rotating mechanism 100 is simplified, thereby helping implement lightness and thinning of the foldable electronic device 500. In addition, in this embodiment, the second pressing plate 52 is slidably and rotatably connected to the second main swing arm 32 and the second intermediate swing arm 42, so that the second pressing plate 52 can rotate relative to the fixed base 10 at the same time as the second main swing arm 32 and the second intermediate swing arm 42, thereby implementing rotation of the second pressing plate 52 relative to the fixed base 10. In this way, stability of rotation of the second pressing plate 52 can be improved. In addition, the pressing plate swing arm can be saved, so that the structure of the rotating mechanism 100 is further simplified, thereby helping implement lightness and thinning of the foldable electronic device 500.

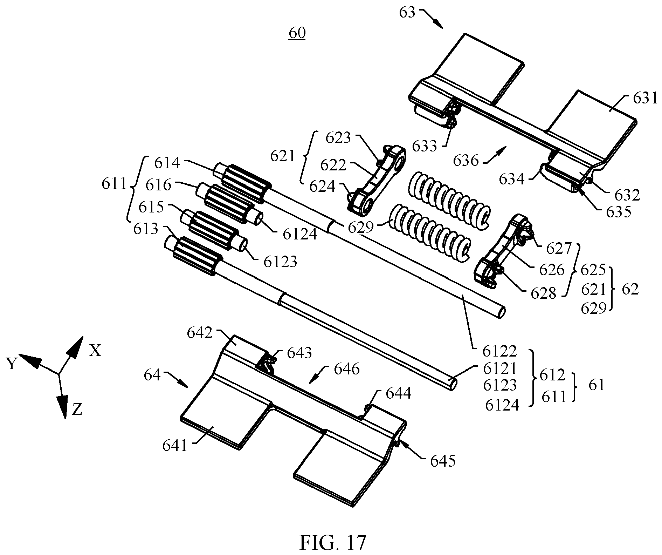

Referring to FIG. 17, FIG. 17 is a schematic exploded view of a structure of the synchronization assembly 60 in the rotating mechanism 100 shown in FIG. 6.

The synchronization assembly 60 includes the synchronization member 61, the damping member 62, the first synchronization swing arm 63, and the second synchronization swing arm 64. Both the first synchronization swing arm 63 and the second synchronization swing arm 64 are hinged to the damping member 62, and the first synchronization swing arm 63 and the second synchronization swing arm 64 are respectively located on two opposite sides of the damping member 62 in the X direction. The synchronization member 61 is fixedly connected to the first synchronization swing arm 63 and the second synchronization swing arm 64. When rotating, the first synchronization swing arm 63 drives the synchronization member 61 to rotate, to drive the second synchronization swing arm 64 to rotate, so that synchronous movement of the first synchronization swing arm 63 and the second synchronization swing arm 64 is implemented. In addition, when rotating, the first synchronization swing arm 63 and the second synchronization swing arm 64 abut against the damping member 62, so that the damping member 62 generates a damping force, thereby providing a damping hand feel for rotation of the rotating mechanism 100.

The synchronization member 61 includes a synchronization gear 611 and a rotating rod 612. The rotating rod 612 includes a first rotating rod 6121, a second rotating rod 6122, a third rotating rod 6123, and a fourth rotating rod 6124. Extension directions of all of the first rotating rod 6121, the second rotating rod 6122, the third rotating rod 6123, and the fourth rotating rod 6124 are parallel to the Y direction, and the first rotating rod 6121, the second rotating rod 6122, the third rotating rod 6123, and the fourth rotating rod 6124 are disposed side by side in the X direction, and are all rotatably connected to the fixed base 10. In this embodiment, the first rotating rod 6121 and the second rotating rod 6122 each are provided with a flat shaft part. The flat shaft part of the first rotating rod 6121 is configured to be fixedly connected to the first synchronization swing arm 63, and the flat shaft part of the second rotating rod 6122 is configured to be fixedly connected to the second synchronization swing arm 64.

The synchronization gear 611 includes a first gear 613, a second gear 614, a third gear 615, and a fourth gear 616. Extension directions of all of the first gear 613, the second gear 614, the third gear 615, and the fourth gear 616 are parallel to the Y direction, and the first gear 613, the second gear 614, the third gear 615, and the fourth gear 616 are disposed side by side in the X direction. The first gear 613 is sleeved on an outer circumference of the first rotating rod 6121, and is fixedly connected to the first rotating rod 6121. The second gear 614 is sleeved on an outer circumference of the second rotating rod 6122, and is fixedly connected to the second rotating rod 6122. The third gear 615 is sleeved on an outer circumference of the third rotating rod 6123, and is fixedly connected to the third rotating rod 6123. The fourth gear 616 is sleeved on an outer circumference of the fourth rotating rod 6124, and is fixedly connected to the fourth rotating rod 6124. In addition, the third gear 615 and the fourth gear 616 are located between the first gear 613 and the second gear 614, the first gear 613 is engaged with the third gear 615, the third gear 615 is engaged with the fourth gear 616, and the fourth gear 616 is engaged with the second gear 614. When rotating, the first rotating rod 6121 drives the first gear 613 to rotate. The first gear 613 drives the third gear 615 to rotate, the third gear 615 drives the fourth gear 616 to rotate, the fourth gear 616 drives the second gear 614 to rotate, and the second gear 614 drives the second rotating rod 6122 to rotate.

The first synchronization swing arm 63 includes a first synchronization swing body 631, a first synchronization shaft seat 632, a first hinge body 633, and a third hinge body 634. In this embodiment, the first synchronization swing body 631 includes two swing sub-bodies, and the two swing sub-bodies are spaced apart. The two swing sub-bodies are respectively installed in the two first sliding grooves 213. In another embodiment, the first synchronization swing body 631 may alternatively be of an integral structure. The first synchronization shaft seat 632 is connected to an end of the first synchronization swing body 631, and is fixedly connected to the first synchronization swing body 631. The first synchronization shaft seat 632 is provided with a first hole 635, and an extension direction of the first hole 635 is parallel to the Y direction. The first synchronization shaft seat 632 is provided with a first receiving notch 636. The first receiving notch 636 is located in a middle portion of the first synchronization shaft seat 632. Both the first hinge body 633 and the third hinge body 634 are fixedly connected to the first synchronization shaft seat 632, and face the first receiving notch 636. The first hinge body 633 includes protrusions and a plurality of recess portions (not marked in the figure), and the plurality of protrusions and the plurality of recess portions are alternately arranged in a peripheral direction of the first hole 635. A structure of the third hinge body 634 is the same as a structure of the first hinge body 633.

A structure of the second synchronization swing arm 64 is the same as a structure of the first synchronization swing arm 63, and the second synchronization swing arm 64 and the first synchronization swing arm 63 are of structures symmetrical to each other. The second synchronization swing arm 64 includes a second synchronization swing body 641, a second synchronization shaft seat 642, a second hinge body 643, and a fourth hinge body 644. The second synchronization shaft seat 642 is provided with a second hole 645, and an extension direction of the second hole 645 is parallel to the Y direction. The second synchronization shaft seat 642 is provided with a second receiving notch 646. Both the second hinge body 643 and the fourth hinge body 644 are fixedly connected to the second synchronization shaft seat 642, and face the second receiving notch 646. Structures of the second hinge body 643 and the fourth hinge body 644 are the same as the structure of the first hinge body 633.

The damping member 62 includes a first baffle plate 621, a second baffle plate 625, and a damping spring 629. The first baffle plate 621 includes a first baffle plate body 622, a first hinge seat 623, and a second hinge seat 624. The first hinge seat 623 and the second hinge seat 624 are spaced apart on a surface of the first baffle plate body 622. A structure of the first hinge seat 623 matches the structure of the first hinge body 633, and a structure of the second hinge seat 624 matches the structure of the second hinge body 643. A structure of the second baffle plate 625 is the same as a structure of the first baffle plate 621. The second baffle plate 625 includes a second baffle plate body 626, a third hinge seat 627, and a fourth hinge seat 628. A structure of the third hinge seat 627 matches the structure of the third hinge body 634, and a structure of the fourth hinge seat 628 matches a structure of the fourth hinge body 644. The first baffle plate 621 and the second baffle plate 625 are spaced apart and disposed in parallel in the Y direction. A surface that is of the first baffle plate 621 and that faces away from the first hinge seat 623 is opposite to a surface that is of the second baffle plate 625 and that faces away from the third hinge seat 627. In this embodiment, there are two damping springs 629. In another embodiment, there may alternatively be one, three, or at least four damping springs 629. The damping spring 629 is installed between the first baffle plate 621 and the second baffle plate 625, and is fixedly connected to the first baffle plate 621 and the second baffle plate 625.

Referring to FIG. 5 together, the synchronization assembly 60 is installed on the fixed base 10. The first rotating rod 6121, the second rotating rod 6122, the third rotating rod 6123, and the fourth rotating rod 6124 of the synchronization member 61 are all rotatably connected to the fixed base 10. The first synchronization swing arm 63 and the second synchronization swing arm 64 are respectively located on the two opposite sides of the fixed base 10 in the X direction. In addition, the first rotating rod 6121 passes through the first rotating hole 216, and is fixedly connected to the first synchronization shaft seat 632. The second rotating rod 6122 passes through the second rotating hole 218, and is fixedly connected to the second synchronization shaft seat 642. The first synchronization swing body 631 is installed in the first sliding groove 213 of the first fastening frame 21, and is capable of sliding along the first sliding groove 213. The second synchronization swing body 641 is installed in a fourth sliding groove 24 in the second sliding groove 223 of the second fastening frame 22, and is capable of sliding along the second sliding groove 223.

The damping member 62 is installed in the fixed base 10, and is located between the first synchronization swing arm 63 and the second synchronization swing arm 64. Both the first baffle plate 621 and the second baffle plate 625 are sleeved on outer circumferences of the first rotating rod 6121 and the second rotating rod 6122, and are capable of moving in the Y direction relative to the first rotating rod 6121 and the second rotating rod 6122. The first hinge body 633 is hinged to the first hinge seat 623, the third hinge body 634 is hinged to the third hinge seat 627, the second hinge body 643 is hinged to the second hinge seat 624, and the fourth hinge body 644 is hinged to the fourth hinge seat 628.

When rotating, the first fastening frame 21 drives the first synchronization swing arm 63 to rotate, and enables the first synchronization swing body 631 of the first synchronization swing arm 63 to slide in the first sliding groove 213. In addition, when rotating, the first synchronization swing arm 63 drives the first rotating rod 6121 to synchronously rotate, to drive the first gear 613 to rotate. When rotating, the first gear 613 drives the third gear 615 and the fourth gear 616 to rotate, to drive the second gear 614 to rotate. When rotating, the second gear 614 drives the second rotating rod 6122 to rotate, to drive the second synchronization swing arm 64 to rotate, drive the second fastening frame 22 to rotate, and enable the second synchronization swing body 641 to slide in the second sliding groove 223, so that synchronous rotation of the first synchronization swing arm 63 and the second synchronization swing arm 64 and synchronous rotation of the first fastening frame 21 and the second fastening frame 22 are implemented.

In addition, when rotating, the first synchronization swing arm 63 drives the first hinge body 633 and the third hinge body 634 to synchronously rotate. When rotating, the first hinge body 633 repeatedly pushes the first hinge seat 623 to move in the Y direction, and drives the first baffle plate 621 to move. When rotating, the third hinge body 634 repeatedly pushes the third hinge seat 627 to move in the Y direction, and drives the second baffle plate 625 to move. The first baffle plate 621 and the second baffle plate 625 move in opposite directions to compress the damping spring 629, so that the damping spring 629 generates an elastic force. An elastic restoring force of the damping spring 629 acts on the first hinge seat 623 and the third hinge seat 627, so that the first hinge seat 623 squeezes the first hinge body 633, and the third hinge seat 627 squeezes the third hinge body 634, thereby providing a damping force for rotation of the first synchronization swing arm 63. The damping force of the first synchronization swing arm 63 acts on the first housing 210 through the first fastening frame 21, so that a damping hand feel is provided for the user.

When rotating, the second synchronization swing arm 64 drives the second hinge body 643 and the fourth hinge body 644 to synchronously rotate. When rotating, the second hinge body 643 repeatedly pushes the second hinge seat 624 to move in the Y direction, and drives the first baffle plate 621 to move. When rotating, the fourth hinge body 644 repeatedly pushes the fourth hinge seat 628 to move in the Y direction, and drives the second baffle plate 625 to move. The first baffle plate 621 and the second baffle plate 625 move in opposite directions to compress the damping spring 629, so that the damping spring 629 generates an elastic force. An elastic restoring force of the damping spring 629 acts on the second hinge seat 624 and the fourth hinge seat 628, so that the second hinge seat 624 squeezes the second hinge body 643, and the fourth hinge seat 628 squeezes the fourth hinge body 644, thereby providing a damping force for rotation of the second synchronization swing arm 64. The damping force of the second synchronization swing arm 64 acts on the second housing 220 through the second fastening frame 22, so that a damping hand feel is provided for the user.

Rotation directions of the first synchronization swing arm 63 and the second synchronization swing arm 64 are opposite. For example, when the rotating mechanism 100 switches from the fully unfolded state to the folded state, the first fastening frame 21, the first synchronization swing arm 63, and the first rotating rod 6121 rotate clockwise, and the second fastening frame 22, the second synchronization swing arm 64, and the second rotating rod 6122 rotate counterclockwise. When the rotating mechanism 100 switches from the folded state to the fully unfolded state, the first fastening frame 21, the first synchronization swing arm 63, and the first rotating rod 6121 rotate counterclockwise, and the second fastening frame 22, the second synchronization swing arm 64, and the second rotating rod 6122 rotate clockwise.

In this embodiment, the synchronization member 61 is disposed, and when rotating, the first synchronization swing arm 63 can drive, by using the synchronization member 61, the second synchronization swing arm 64 to rotate, so that synchronous rotation of the first synchronization swing arm 63 and the second synchronization swing arm 64 can be implemented, thereby implementing synchronous rotation of the rotating mechanism 100 and the foldable electronic device 500. In addition, in this embodiment, the damping member 62 is disposed, and when the first synchronization swing arm 63 and the second synchronization swing arm 64 rotate relative to the fixed base 10, the damping member 62 always abuts against the first synchronization swing arm 63 and the second synchronization swing arm 64, to generate a damping force, so that a damping hand feel is provided for the user, and use experience of the user is improved.

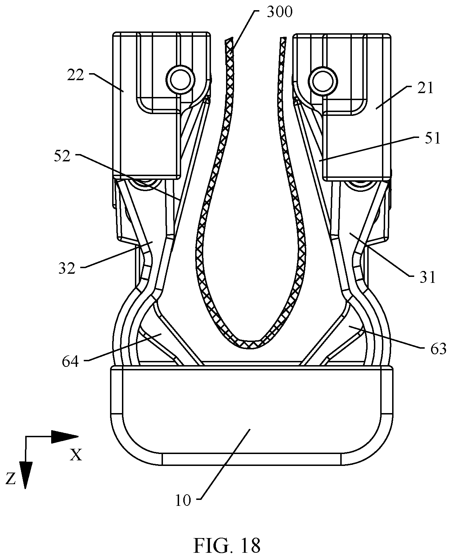

Referring to FIG. 18, FIG. 18 is a schematic diagram of a structure of the rotating mechanism 100 shown in FIG. 5 in the folded state.

When the rotating mechanism 100 is in the fully unfolded state, the first pressing plate 51, the second pressing plate 52, and the fixed base 10 jointly support the display 300, to ensure good display of the display 300. When the rotating mechanism 100 is in the folded state, the foldable part 330 of the display 300 is located on an inner side of the rotating mechanism 100. Specifically, the foldable part 330 is located in avoidance space. For example, the avoidance space is approximately in a "water drop" shape. In this case, the rotating mechanism 100 can avoid an R angle formed when the foldable part 330 is bent, so that the foldable part 330 is not bent at a relatively large angle, to avoid undesirable phenomena such as a crease on the display 300, thereby helping prolong a service life of the display 300.

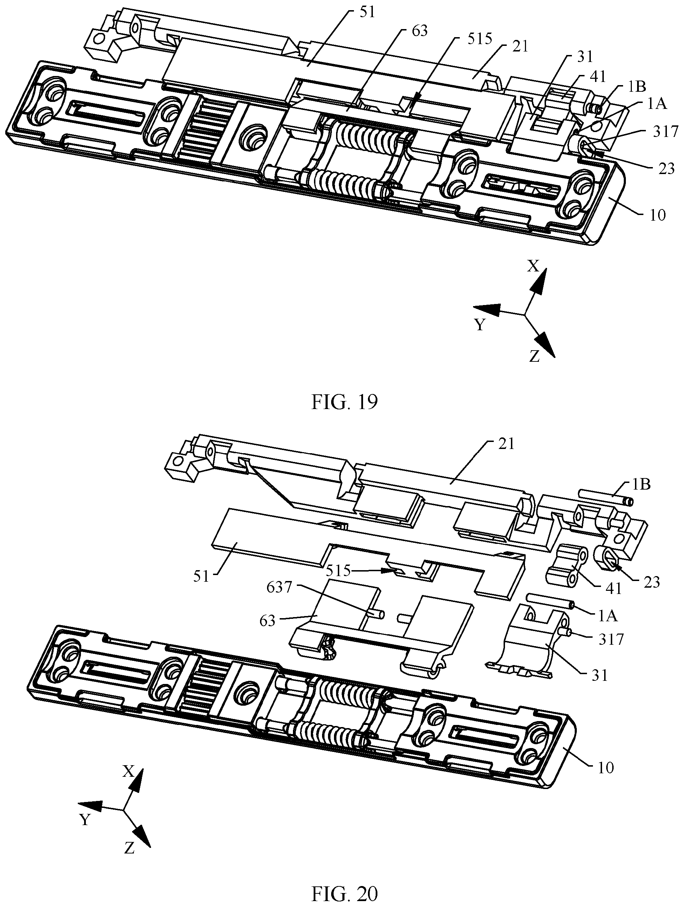

Referring to FIG. 19 and FIG. 20, FIG. 19 is a schematic diagram of a partial structure of the rotating mechanism 100 according to a second embodiment of this application, and FIG. 20 is a schematic exploded view of a partial structure of the rotating mechanism 100 shown in FIG. 19.

The embodiment shown in FIG. 19 differs from the embodiment shown in FIG. 5 in that the first main swing arm 31 is rotatably and slidably connected to the first fastening frame 21, the first pressing plate 51 is rotatably and slidably connected to the first synchronization swing arm 63, the second main swing arm 32 is rotatably and slidably connected to the second fastening frame 22, and the second pressing plate 52 is rotatably and slidably connected to the second synchronization swing arm 64.

The first main swing arm 31 is further provided with a first auxiliary shaft body 317, and the first auxiliary shaft body 317 is fastened to a side surface of the first main swing arm 31. The first fastening frame 21 is provided with a fifth sliding hole 23 adapted to the first auxiliary shaft body 317. The first auxiliary shaft body 317 is installed in the fifth sliding hole 23, and is capable of rotating and sliding in the fifth sliding hole 23. The second main swing arm 32 is further provided with a second auxiliary shaft body (not shown in the figure), and the second auxiliary shaft body is fastened to a side surface of the second main swing arm 32. The second fastening frame 22 is provided with a sixth sliding hole (not shown in the figure) adapted to the second auxiliary shaft body. The second auxiliary shaft body is installed in the sixth sliding hole, and is capable of rotating and sliding in the sixth sliding hole.

The first synchronization swing arm 63 is provided with fifth shaft bodies 637. In this embodiment, there are two fifth shaft bodies 637. Extension directions of the two fifth shaft bodies 637 are parallel to the Y direction, and the two fifth shaft bodies 637 are spaced apart. The first pressing plate 51 is provided with a seventh sliding hole 515 that fits with the fifth shaft body 637, and an extension direction of the seventh sliding hole 515 is parallel to the X direction. One fifth shaft body 637 is installed in one seventh sliding hole 515, and each fifth shaft body 637 is capable of sliding and rotating in a corresponding seventh sliding hole 515. The second synchronization swing arm 64 is provided with a sixth shaft body (not shown in the figure). An extension direction of the sixth shaft body is parallel to the Y direction. The second pressing plate 52 is provided with an eighth sliding hole (not shown in the figure) that fits with the sixth shaft body, and an extension direction of the eighth sliding hole is parallel to the X direction. The sixth shaft body is installed in the eighth sliding hole, and the sixth shaft body is capable of sliding and rotating in the corresponding eighth sliding hole.

When rotating relative to the fixed base 10, the first fastening frame 21 drives the first intermediate swing arm 41 to rotate, and the first intermediate swing arm 41 drives the first main swing arm 31 to rotate. When rotating relative to the fixed base 10, the first fastening frame 21 further drives the first main swing arm 31 to rotate relative to the fixed base 10 and the first main swing arm 31 to rotate and slide relative to the first fastening frame 21. In addition, when rotating relative to the fixed base 10, the first fastening frame 21 further drives the first pressing plate 51 and the first synchronization swing arm 63 to rotate relative to the fixed base 10, and the first pressing plate 51 rotates and slides relative to the first synchronization swing arm 63. When rotating relative to the fixed base 10, the second fastening frame 22 drives the second intermediate swing arm 42 to rotate, and the second intermediate swing arm 42 drives the second main swing arm 32 to rotate. When rotating relative to the fixed base 10, the second fastening frame 22 further drives the second main swing arm 32 to rotate relative to the fixed base 10 and the second main swing arm 32 to rotate and slide relative to the second fastening frame 22. In addition, when rotating relative to the fixed base 10, the second fastening frame 22 further drives the second pressing plate 52 and the second synchronization swing arm 64 to rotate relative to the fixed base 10, and the second pressing plate 52 rotates and slides relative to the second synchronization swing arm 64.

In this embodiment, when being rotatably connected to the first intermediate swing arm 41, the first main swing arm 31 is further rotatably and slidably connected to the first fastening frame 21, so that stability of rotation of the first main swing arm 31 and the first fastening frame 21 can be improved. When being rotatably connected to the second intermediate swing arm 42, the second main swing arm 32 is further rotatably and slidably connected to the second fastening frame 22, so that stability of rotation of the second main swing arm 32 and the second fastening frame 22 can be improved. In addition, when being rotatably connected to the first fastening frame 21, the first synchronization swing arm 63 is further rotatably connected to the first pressing plate 51, so that stability of rotation of the first pressing plate 51 can be improved. When being rotatably connected to the second fastening frame 22, the second synchronization swing arm 64 is further rotatably connected to the second pressing plate 52, so that stability of rotation of the second pressing plate 52 can be improved. In addition, a pressing plate swing arm can be further saved to simplify a structure of the rotating mechanism 100.

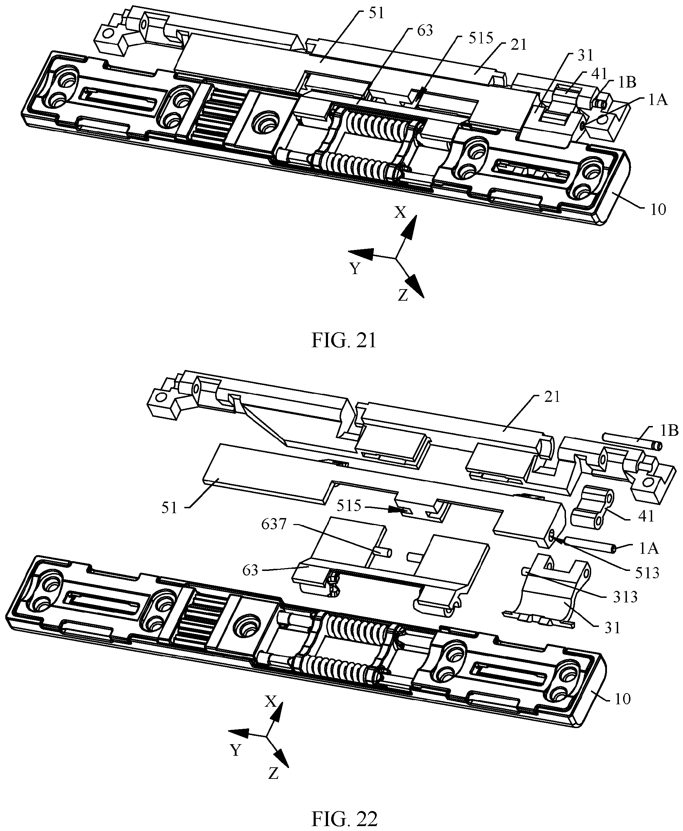

Referring to FIG. 21 and FIG. 22, FIG. 21 is a schematic diagram of a partial structure of the rotating mechanism 100 according to a third embodiment of this application, and FIG. 22 is a schematic exploded view of a partial structure of the rotating mechanism 100 shown in FIG. 21.

The embodiment shown in FIG. 21 differs from the embodiment shown in FIG. 5 in that the first shaft body 313 of the first main swing arm 31 is rotatably and slidably connected to the first pressing plate 51, the first synchronization swing arm 63 is rotatably and slidably connected to the first pressing plate 51, the third shaft body 323 of the second main swing arm 32 is rotatably and slidably connected to the second pressing plate 52, and the second synchronization swing arm 64 is rotatably and slidably connected to the second pressing plate 52.

The first shaft body 313 is installed in the first sliding hole 513, and is capable of rotating and sliding in the first sliding hole 513. The third shaft body 323 is installed in the third sliding hole 523, and is capable of rotating and sliding in the third sliding hole 523. The first synchronization swing arm 63 is provided with fifth shaft bodies 637. In this embodiment, there are two fifth shaft bodies 637. Extension directions of the two fifth shaft bodies 637 are parallel to the Y direction, and the two fifth shaft bodies 637 are spaced apart. The first pressing plate 51 is provided with a seventh sliding hole 515 that fits with the fifth shaft body 637, and an extension direction of the seventh sliding hole 515 is parallel to the X direction. One fifth shaft body 637 is installed in one seventh sliding hole 515, and each fifth shaft body 637 is capable of sliding and rotating in a corresponding seventh sliding hole 515. The second synchronization swing arm 64 is provided with a sixth shaft body (not shown in the figure). An extension direction of the sixth shaft body is parallel to the Y direction. The second pressing plate 52 is provided with an eighth sliding hole (not shown in the figure) that fits with the sixth shaft body, and an extension direction of the eighth sliding hole is parallel to the X direction. The sixth shaft body is installed in the eighth sliding hole, and the sixth shaft body is capable of sliding and rotating in the corresponding eighth sliding hole.

When rotating relative to the fixed base 10, the first fastening frame 21 drives the first intermediate swing arm 41 to rotate, the first intermediate swing arm 41 drives the first main swing arm 31 to rotate relative to the fixed base 10, and the first main swing arm 31 further rotates and slides relative to the first pressing plate 51 when rotating relative to the fixed base 10. In addition, when rotating relative to the fixed base 10, the first fastening frame 21 further drives the first pressing plate 51 and the first synchronization swing arm 63 to rotate relative to the fixed base 10, and the first pressing plate 51 rotates and slides relative to the first synchronization swing arm 63. When rotating relative to the fixed base 10, the second fastening frame 22 drives the second intermediate swing arm 42 to rotate, the second intermediate swing arm 42 drives the second main swing arm 32 to rotate, and the second main swing arm 32 further rotates and slides relative to the second pressing plate 52 when rotating relative to the fixed base 10. In addition, when rotating relative to the fixed base 10, the second fastening frame 22 further drives the second pressing plate 52 and the second synchronization swing arm 64 to rotate relative to the fixed base 10, and the second pressing plate 52 rotates and slides relative to the second synchronization swing arm 64.

In this embodiment, when being rotatably connected to the first intermediate swing arm 41, the first main swing arm 31 is further rotatably and slidably connected to the first pressing plate 51, so that stability of rotation of the first main swing arm 31 and the first pressing plate 51 can be improved. In addition, when being rotatably connected to the first fastening frame 21, the first synchronization swing arm 63 is further rotatably connected to the first pressing plate 51, so that stability of rotation of the first pressing plate 51 can be further improved. In addition, when being rotatably connected to the second intermediate swing arm 42, the second main swing arm 32 is further rotatably and slidably connected to the second pressing plate 52, so that stability of rotation of the second main swing arm 32 and the second pressing plate 52 can be improved. In addition, when being rotatably connected to the second fastening frame 22, the second synchronization swing arm 64 is further rotatably connected to the second pressing plate 52, so that stability of rotation of the second pressing plate 52 can be further improved. In addition, a pressing plate swing arm can be further saved to simplify a structure of the rotating mechanism 100.

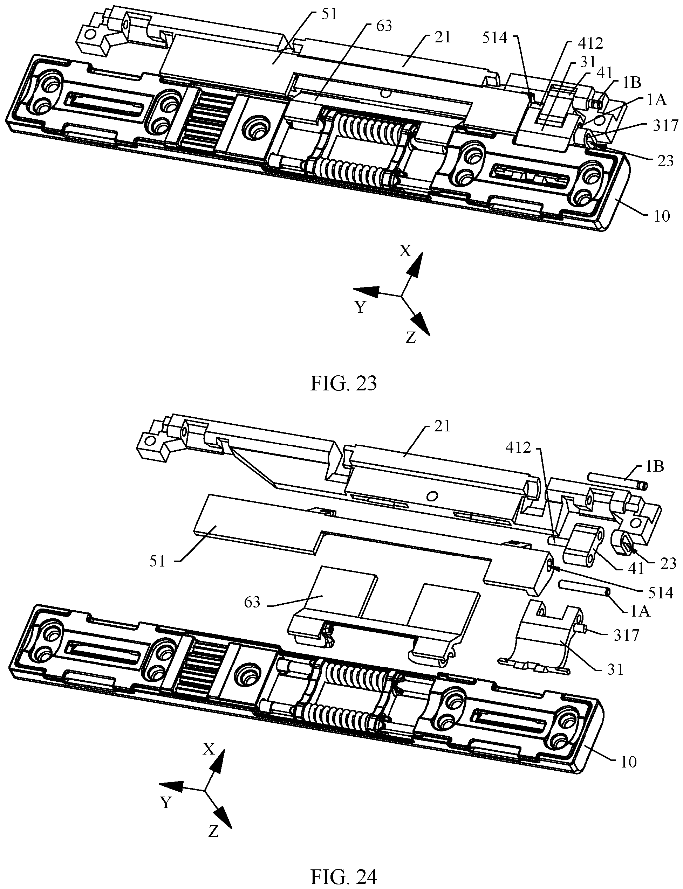

Referring to FIG. 23 and FIG. 24, FIG. 23 is a schematic diagram of a partial structure of the rotating mechanism 100 according to a fourth embodiment of this application, and FIG. 24 is a schematic exploded view of a partial structure of the rotating mechanism 100 shown in FIG. 23.

The embodiment shown in FIG. 23 differs from the embodiment shown in FIG. 5 in that the first main swing arm 31 is rotatably and slidably connected to the first fastening frame 21, the first intermediate swing arm 41 is rotatably and slidably connected to the first pressing plate 51, the second main swing arm 32 is rotatably and slidably connected to the second fastening frame 22, and the second intermediate swing arm 42 is rotatably and slidably connected to the second pressing plate 52.

The first main swing arm 31 is further provided with a first auxiliary shaft body 317, and the first auxiliary shaft body 317 is fastened to a side surface of the first main swing arm 31. The first fastening frame 21 is provided with a fifth sliding hole 23 adapted to the first auxiliary shaft body 317. The first auxiliary shaft body 317 is installed in the fifth sliding hole 23, and is capable of rotating and sliding in the fifth sliding hole 23. The second main swing arm 32 is further provided with a second auxiliary shaft body (not shown in the figure), and the second auxiliary shaft body is fastened to a side surface of the second main swing arm 32. The second fastening frame 22 is provided with a sixth sliding hole (not shown in the figure) adapted to the second auxiliary shaft body. The second auxiliary shaft body is installed in the sixth sliding hole, and is capable of rotating and sliding in the sixth sliding hole. The second shaft body 412 of the first intermediate swing arm 41 is installed in the second sliding hole 514, and is capable of rotating and sliding in the second sliding hole 514. The fourth shaft body 422 of the second intermediate swing arm 42 is installed in the fourth sliding hole 524, and is capable of rotating and sliding in the fourth sliding hole 524.

When rotating relative to the fixed base 10, the first fastening frame 21 drives the first intermediate swing arm 41 to rotate, the first intermediate swing arm 41 drives the first main swing arm 31 to rotate, and the first fastening frame 21 enables the first intermediate swing arm 41 to rotate and slide relative to the first pressing plate 51. When rotating relative to the fixed base 10, the first fastening frame 21 further drives the first main swing arm 31 to rotate relative to the fixed base 10 and the first main swing arm 31 to rotate and slide relative to the first fastening frame 21. In addition, when rotating relative to the fixed base 10, the first fastening frame 21 further drives the first pressing plate 51 and the first synchronization swing arm 63 to rotate relative to the fixed base 10, and the first pressing plate 51 rotates and slides relative to the first synchronization swing arm 63. When rotating relative to the fixed base 10, the second fastening frame 22 drives the second intermediate swing arm 42 to rotate, the second intermediate swing arm 42 drives the second main swing arm 32 to rotate, and the second fastening frame 22 enables the second intermediate swing arm 42 to rotate and slide relative to the second pressing plate 52. When rotating relative to the fixed base 10, the second fastening frame 22 further drives the second main swing arm 32 to rotate relative to the fixed base 10 and the second main swing arm 32 to rotate and slide relative to the second fastening frame 22. In addition, when rotating relative to the fixed base 10, the second fastening frame 22 further drives the second pressing plate 52 and the second synchronization swing arm 64 to rotate relative to the fixed base 10, and the second pressing plate 52 rotates and slides relative to the second synchronization swing arm 64.

In this embodiment, when being rotatably connected to the first intermediate swing arm 41, the first main swing arm 31 is further rotatably and slidably connected to the first fastening frame 21, so that stability of rotation of the first main swing arm 31 and the first fastening frame 21 can be improved. When being rotatably connected to the second intermediate swing arm 42, the second main swing arm 32 is further rotatably and slidably connected to the second fastening frame 22, so that stability of rotation of the second main swing arm 32 and the second fastening frame 22 can be improved. In addition, when being rotatably connected to the first fastening frame 21, the first synchronization swing arm 63 is further rotatably connected to the first pressing plate 51, so that stability of rotation of the first pressing plate 51 can be improved. When being rotatably connected to the second fastening frame 22, the second synchronization swing arm 64 is further rotatably connected to the second pressing plate 52, so that stability of rotation of the second pressing plate 52 can be improved. In addition, a pressing plate swing arm can be further saved to simplify a structure of the rotating mechanism 100.

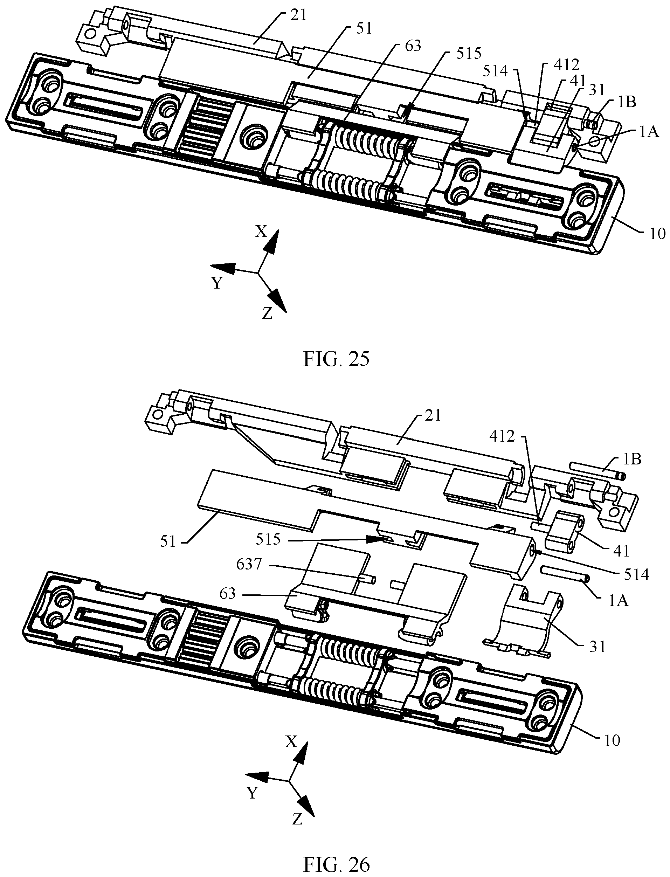

Referring to FIG. 25 and FIG. 26, FIG. 25 is a schematic diagram of a partial structure of the rotating mechanism 100 according to a fifth embodiment of this application, and FIG. 26 is a schematic exploded view of a partial structure of the rotating mechanism 100 shown in FIG. 25.

The embodiment shown in FIG. 25 differs from the embodiment shown in FIG. 5 in that the first intermediate swing arm 41 is rotatably and slidably connected to the first pressing plate 51, and the second intermediate swing arm 42 is rotatably and slidably connected to the second pressing plate 52. The first pressing plate 51 is rotatably and slidably connected to the first synchronization swing arm 63, and the second pressing plate 52 is rotatably and slidably connected to the second synchronization swing arm 64.

The second shaft body 412 of the first intermediate swing arm 41 is installed in the second sliding hole 514, and is capable of rotating and sliding in the second sliding hole 514. The fourth shaft body 422 of the second intermediate swing arm 42 is installed in the fourth sliding hole 524, and is capable of rotating and sliding in the fourth sliding hole 524. The first synchronization swing arm 63 is provided with fifth shaft bodies 637. In this embodiment, there are two fifth shaft bodies 637. Extension directions of the two fifth shaft bodies 637 are parallel to the Y direction, and the two fifth shaft bodies 637 are spaced apart. The first pressing plate 51 is provided with a seventh sliding hole 515 that fits with the fifth shaft body 637, and an extension direction of the seventh sliding hole 515 is parallel to the X direction. One fifth shaft body 637 is installed in one seventh sliding hole 515, and each fifth shaft body 637 is capable of sliding and rotating in a corresponding seventh sliding hole 515. The second synchronization swing arm 64 is provided with a sixth shaft body (not shown in the figure). An extension direction of the sixth shaft body is parallel to the Y direction. The second pressing plate 52 is provided with an eighth sliding hole (not shown in the figure) that fits with the sixth shaft body, and an extension direction of the eighth sliding hole is parallel to the X direction. The sixth shaft body is installed in the eighth sliding hole, and the sixth shaft body is capable of sliding and rotating in the corresponding eighth sliding hole.

When rotating relative to the fixed base 10, the first fastening frame 21 drives the first intermediate swing arm 41 to rotate, the first intermediate swing arm 41 drives the first main swing arm 31 to rotate relative to the fixed base 10, and the first fastening frame 21 enables the first intermediate swing arm 41 to rotate and slide relative to the first pressing plate 51. In addition, when rotating relative to the fixed base 10, the first fastening frame 21 further drives the first pressing plate 51 and the first synchronization swing arm 63 to rotate relative to the fixed base 10, and the first pressing plate 51 rotates and slides relative to the first synchronization swing arm 63. When rotating relative to the fixed base 10, the second fastening frame 22 drives the second intermediate swing arm 42 to rotate, the second intermediate swing arm 42 drives the second main swing arm 32 to rotate, and the second fastening frame 22 enables the second intermediate swing arm 42 to rotate and slide relative to the second pressing plate 52. In addition, when rotating relative to the fixed base 10, the second fastening frame 22 further drives the second pressing plate 52 and the second synchronization swing arm 64 to rotate relative to the fixed base 10, and the second pressing plate 52 rotates and slides relative to the second synchronization swing arm 64.

In this embodiment, when being rotatably connected to the first fastening frame 21, the first synchronization swing arm 63 is further rotatably connected to the first pressing plate 51, so that stability of rotation of the first pressing plate 51 can be improved. When being rotatably connected to the second fastening frame 22, the second synchronization swing arm 64 is further rotatably connected to the second pressing plate 52, so that stability of rotation of the second pressing plate 52 can be improved. In addition, a pressing plate swing arm can be further saved to simplify a structure of the rotating mechanism 100. In addition, in this embodiment, when being rotatably connected to the first intermediate swing arm 41, the first main swing arm 31 is further rotatably and slidably connected to the first fastening frame 21, so that stability of rotation of the first main swing arm 31 and the first fastening frame 21 can be improved. When being rotatably connected to the second intermediate swing arm 42, the second main swing arm 32 is further rotatably and slidably connected to the second fastening frame 22, so that stability of rotation of the second main swing arm 32 and the second fastening frame 22 can be improved.

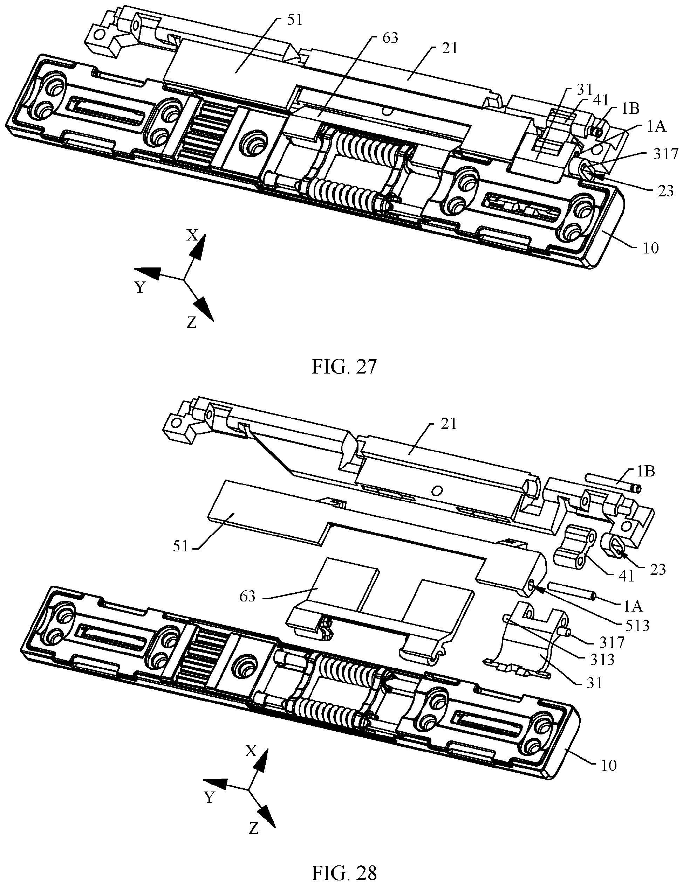

Referring to FIG. 27 and FIG. 28, FIG. 27 is a schematic diagram of a partial structure of the rotating mechanism 100 according to a sixth embodiment of this application, and FIG. 28 is a schematic exploded view of a partial structure of the rotating mechanism 100 shown in FIG. 27.

The embodiment shown in FIG. 27 differs from the embodiment shown in FIG. 5 in that the first main swing arm 31 is rotatably and slidably connected to the first pressing plate 51, and the first main swing arm 31 is further rotatably and slidably connected to the first fastening frame 21. The second main swing arm 32 is rotatably and slidably connected to the second pressing plate 52, and the second main swing arm 32 is further rotatably and slidably connected to the second fastening frame 22.

The first main swing arm 31 is further provided with a first auxiliary shaft body 317, and the first auxiliary shaft body 317 is fastened to a side surface of the first main swing arm 31, and is disposed opposite to the first shaft body 313. The first fastening frame 21 is provided with a fifth sliding hole 23 adapted to the first shaft body 313. The first shaft body 313 is installed in the first sliding hole 513, and is capable of rotating and sliding in the first sliding hole 513. The first auxiliary shaft body 317 is installed in the fifth sliding hole 23, and is capable of rotating and sliding in the fifth sliding hole 23. The second main swing arm 32 is further provided with a second auxiliary shaft body (not shown in the figure), and the second auxiliary shaft body is fastened to a side surface of the second main swing arm 32, and is disposed opposite to the third shaft body 323. The second fastening frame 22 is provided with a sixth sliding hole (not shown in the figure) adapted to the second auxiliary shaft body. The third shaft body 323 is installed in the third sliding hole 523, and is capable of rotating and sliding in the third sliding hole 523. The second auxiliary shaft body is installed in the sixth sliding hole, and is capable of rotating and sliding in the sixth sliding hole.

When rotating relative to the fixed base 10, the first fastening frame 21 drives the first intermediate swing arm 41 to rotate, the first intermediate swing arm 41 drives the first main swing arm 31 to rotate relative to the fixed base 10, and the first main swing arm 31 further rotates and slides relative to the first pressing plate 51 when rotating relative to the fixed base 10. When rotating relative to the fixed base 10, the first fastening frame 21 further drives the first main swing arm 31 to rotate relative to the fixed base 10 and the first main swing arm 31 to rotate and slide relative to the first fastening frame 21. When rotating relative to the fixed base 10, the second fastening frame 22 drives the second intermediate swing arm 42 to rotate, the second intermediate swing arm 42 drives the second main swing arm 32 to rotate, and the second main swing arm 32 further rotates and slides relative to the second pressing plate 52 when rotating relative to the fixed base 10. When rotating relative to the fixed base 10, the second fastening frame 22 further drives the second main swing arm 32 to rotate relative to the fixed base 10 and the second main swing arm 32 to rotate and slide relative to the second fastening frame 22.

In this embodiment, when being rotatably connected to the first intermediate swing arm 41, the first main swing arm 31 is further rotatably and slidably connected to the first pressing plate 51, so that stability of rotation of the first main swing arm 31 and the first pressing plate 51 can be improved. When being rotatably connected to the second intermediate swing arm 42, the second main swing arm 32 is further rotatably and slidably connected to the second pressing plate 52, so that stability of rotation of the second main swing arm 32 and the second pressing plate 52 can be improved. In addition, a pressing plate swing arm can be further saved to simplify a structure of the rotating mechanism 100. In addition, in this embodiment, when being rotatably connected to the first intermediate swing arm 41, the first main swing arm 31 is further rotatably and slidably connected to the first fastening frame 21, so that stability of rotation of the first main swing arm 31 and the first fastening frame 21 can be improved. When being rotatably connected to the second intermediate swing arm 42, the second main swing arm 32 is further rotatably and slidably connected to the second fastening frame 22, so that stability of rotation of the second main swing arm 32 and the second fastening frame 22 can be improved.

The foregoing descriptions are only some embodiments and implementations of this application, and are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A rotating mechanism, comprising a fixed base, a first fastening frame, a second fastening frame, a first main swing arm, and a first intermediate swing arm, wherein
the first fastening frame and the second fastening frame are respectively located on two opposite sides of the fixed base in a width direction, and are capable of rotating relative to the fixed base, and rotation directions of the first fastening frame and the second fastening frame are opposite; and
one end of the first main swing arm is rotatably connected to the fixed base, the other end of the first main swing arm is rotatably connected to the first intermediate swing arm, and an end that is of the first intermediate swing arm and that is away from the first main swing arm is rotatably connected to the first fastening frame.

2. The rotating mechanism according to claim 1, wherein the fixed base comprises a first side and a second side, and the first side and the second side are respectively located on the two opposite sides of the fixed base in the width direction; and the rotating mechanism comprises a folded state, and when the rotating mechanism is in the folded state, the first main swing arm is located between the first side and the second side.

3. The rotating mechanism according to claim 2, wherein when the rotating mechanism is in the folded state, the first intermediate swing arm is tilted toward the fixed base relative to the first main swing arm.

4. The rotating mechanism according to claim 3, wherein the rotating mechanism further comprises a fully unfolded state, when the rotating mechanism is in the fully unfolded state, the first fastening frame is unfolded relative to the second fastening frame, and when the first fastening frame and the second fastening frame rotate toward the fixed base, the first fastening frame drives the first intermediate swing arm to rotate relative to the fixed base, and enables the first intermediate swing arm to rotate relative to the first fastening frame, and the first intermediate swing arm rotates to drive the first main swing arm to rotate relative to the fixed base, and enables the first main swing arm to rotate relative to the first intermediate swing arm, so that the first fastening frame is folded relative to the second fastening frame, and the rotating mechanism is in the folded state.

5. The rotating mechanism according to claim 4, wherein the first main swing arm comprises a first rotating body and a first stop block, and the first stop block is fixedly connected to an end of the first rotating body; and
both the first stop block and the first rotating body are installed in the fixed base, and are capable of rotating in the fixed base, an end that is of the first rotating body and that is away from the first stop block is rotatably connected to the first intermediate swing arm, and when the rotating mechanism is in the folded state, the first stop block abuts against the fixed base.

6. The rotating mechanism according to claim 5, wherein the rotating mechanism further comprises a second main swing arm and a second intermediate swing arm, the second main swing arm is disposed opposite to the first main swing arm, one end of the second main swing arm is rotatably connected to the fixed base, the other end of the second main swing arm is rotatably connected to the second intermediate swing arm, and an end that is of the second intermediate swing arm and that is away from the second main swing arm is rotatably connected to the second fastening frame; and
when rotating relative to the fixed base, the second fastening frame drives the second intermediate swing arm to rotate relative to the fixed base, and enables the second intermediate swing arm to rotate relative to the second fastening frame, and the second intermediate swing arm rotates to drive the second main swing arm to rotate relative to the fixed base, and enables the second main swing arm to rotate relative to the second intermediate swing arm.

7. The rotating mechanism according to claim 6, wherein the rotating mechanism further comprises a first pressing plate and a second pressing plate, the first pressing plate is slidably and rotatably connected to the first fastening frame, and when rotating relative to the fixed base, the first fastening frame is capable of driving the first pressing plate to rotate relative to the fixed base and enabling the first pressing plate to rotate and slide relative to the first fastening frame; and the second pressing plate is slidably connected to the second fastening frame, and when rotating relative to the fixed base, the second pressing plate is capable of driving the second pressing plate to rotate relative to the fixed base and enabling the second pressing plate to rotate and slide relative to the second fastening frame.

8. The rotating mechanism according to claim 7, wherein the first main swing arm and the first pressing plate are disposed side by side in a length direction of the fixed base, and the first main swing arm is rotatably and slidably connected to the first pressing plate; and when the first pressing plate and the first main swing arm rotate relative to the fixed base, the first main swing arm further rotates and slides relative to the first pressing plate.

9. The rotating mechanism according to claim 8, wherein a first shaft body is disposed on a side surface of the first main swing arm, the first shaft body extends toward the first pressing plate, and an extension direction of the first shaft body is parallel to the length direction of the fixed base; and the first pressing plate is provided with a first sliding hole, an extension direction of the first sliding hole intersects the width direction of the fixed base, and the first shaft body is installed in the first sliding hole, and is capable of rotating and sliding in the first sliding hole.

10. The rotating mechanism according to any one of claims 7 to 9, wherein the first intermediate swing arm and the first pressing plate are disposed side by side in the length direction of the fixed base, and the first intermediate swing arm is rotatably and slidably connected to the first pressing plate; and when the first pressing plate and the first intermediate swing arm rotate relative to the fixed base, the first intermediate swing arm further rotates and slides relative to the first pressing plate.

11. The rotating mechanism according to claim 10, wherein a second shaft body is disposed on a side surface of the first intermediate swing arm, the second shaft body extends toward the first pressing plate, and an extension direction of the second shaft body is parallel to the length direction of the fixed base; and the first pressing plate is provided with a second sliding hole, an extension direction of the second sliding hole is parallel to the extension direction of the first sliding hole, and the second shaft body is installed in the second sliding hole, and is capable of rotating and sliding in the second sliding hole.

12. The rotating mechanism according to claim 11, wherein the second main swing arm and the second pressing plate are disposed side by side in the length direction of the fixed base, and the second main swing arm is rotatably and slidably connected to the second pressing plate; and when the second pressing plate and the second main swing arm rotate relative to the fixed base, the second main swing arm further rotates and slides relative to the second pressing plate.

13. The rotating mechanism according to claim 12, wherein the second intermediate swing arm and the second pressing plate are disposed side by side in the length direction of the fixed base, and the second intermediate swing arm is rotatably and slidably connected to the second pressing plate; and when the second pressing plate and the second intermediate swing arm rotate relative to the fixed base, the second intermediate swing arm further rotates and slides relative to the first pressing plate.

14. The rotating mechanism according to claim 6, wherein the rotating mechanism further comprises a synchronization assembly, the synchronization assembly comprises a first synchronization swing arm, a second synchronization swing arm, and a synchronization gear, and the first synchronization swing arm and the second synchronization swing arm are respectively located on two opposite sides of the synchronization gear, and are fixedly connected to the synchronization gear; and the synchronization gear is installed in the fixed base, the first synchronization swing arm is slidably connected to the first fastening frame, and the second synchronization swing arm is slidably connected to the second fastening frame; and
when rotating relative to the fixed base, the first fastening frame is capable of driving the first synchronization swing arm to rotate relative to the fixed base, so that the second synchronization swing arm is driven, by using the synchronization gear, to rotate relative to the fixed base, to drive the second fastening frame to rotate relative to the fixed base.

15. The rotating mechanism according to claim 14, wherein the synchronization assembly further comprises a damping spring, a first hinge seat, and a second hinge seat, the damping spring is installed on the fixed base, and both the first hinge seat and the second hinge seat are fixedly connected to the damping spring; and the first synchronization swing arm comprises a first hinge body, the first hinge body is hinged to the first hinge seat, the second synchronization swing arm comprises a second hinge body, and the second hinge body is hinged to the second hinge seat; and
when the first synchronization swing arm rotates relative to the fixed base, the first hinge body abuts against the first hinge seat, when the second synchronization swing arm rotates relative to the fixed base, the second hinge body abuts against the second hinge seat, and the first hinge seat and the second hinge seat j ointly compress the damping spring, and enable the damping spring to generate an elastic force.

16. A foldable electronic device, comprising a first housing, a second housing, a display, and the rotating mechanism according to any one of claims 1 to 15, wherein the rotating mechanism is connected between the first housing and the second housing, the display is installed on the first housing, the second housing, and the rotating mechanism, and when the rotating mechanism rotates, the first housing and the second housing rotate relative to each other, to drive the display to be bent or unfolded.
